# EUROPEAN PATENT APPLICATION

(11) **EP 4 766 061 A1**
(43) Date of publication of application: **24.06.2026**
(21) Application number: 25728028.9
(22) Date of filing: 22.05.2025
(51) Int. Cl.: H05K 7/20, G02B 27/01

(54) **WEARABLE DEVICE INCLUDING HEAT DISSIPATION SHEETS**

(30) Priority: 26.08.2024 KR 20240114671; 25.10.2024 KR 20240147408
(71) Applicant: Samsung Electronics Co., Ltd, Suwon-si, Gyeonggi-do 16677 (KR)
(72) Inventor: KIM, Hongjun, Suwon-si, Gyeonggi-do 16677 (KR); CHOI, Nakhyun, Suwon-si, Gyeonggi-do 16677 (KR)
(74) Representative: HGF
(86) International application number: PCT/KR2025/006975
(87) International publication number: WO 2026/049209

(57) **Abstract**

A head-wearable device according to an embodiment includes a housing part including a sidewall, one or more electronic components disposed on a printed circuit board, a first heat dissipation sheet facing the printed circuit board, disposed on a first portion of the sidewall, and configured to dissipate heat caused from the one or more electronic components, a second heat dissipation sheet spaced apart from the first heat dissipation sheet, disposed on a second portion of the sidewall, and a speaker spaced apart from the printed circuit board, disposed over the second portion and a third portion of the sidewall through an adhesive on the sidewall, and a third heat dissipation sheet thermally connecting the first heat dissipation sheet and the second heat dissipation sheet.

## Description

### [Technical Field]

The present disclosure relates to a wearable device including heat dissipation sheets.

### [Background Art]

A wearable device may be used in a state of being worn on a user's body. For example, a glasses-type device may be used by being seated on a user's face. The wearable device may include electronic components to provide various functions of the wearable device. The wearable device may include a heat dissipation sheet to dissipate heat caused from the electronic components.

A heat dissipation sheet may be formed from a material such as graphite which has desirable thermal characteristics. Securing other components with respect to a heat dissipation sheet may be difficult, where the heat dissipation sheet comprises a material which does not bond well with a chosen adhesive.

The above-described information may be provided as a related art for the purpose of helping to understand the present disclosure. No claim or determination is raised as to whether any of the above-described information may be applied as prior art related to the present disclosure.

### [Disclosure]

### [Technical Solution]

A head-wearable device is provided. The head-wearable device may comprise a housing part, including a sidewall, contacted with a portion of a user's body when the head-wearable device is worn by the user, and supporting the head-wearable device. The head-wearable device may comprise one or more electronic components disposed on the housing part. The head-wearable device may comprise a first heat dissipation sheet, disposed on a first portion of the sidewall of the housing part, configured to dissipate heat caused from the one or more electronic components. The head-wearable device may comprise a second heat dissipation sheet, spaced apart from the first heat dissipation sheet, disposed on a second portion of the sidewall. The head-wearable device may comprise a speaker, disposed over the second portion of the sidewall and a third portion of the sidewall through an adhesive. The third portion of the sidewall may be positioned between the first portion of the sidewall and the second portion of the sidewall. The head-wearable device may comprise a third heat dissipation sheet, thermally connecting the first heat dissipation sheet and the second heat dissipation sheet. The third heat dissipation sheet may include a first portion, disposed on the sidewall of the housing part, contacted with the first heat dissipation sheet, a second portion, disposed on the sidewall of the housing part, contacted with the second heat dissipation sheet, and a third portion, extending from the first portion of the third heat dissipation sheet to the second portion of the third heat dissipation sheet, disposed in the third portion of the sidewall. A material forming the third heat dissipation sheet may be different from a material forming the first heat dissipation sheet or the second heat dissipation sheet.

A head-wearable device is provided. The head-wearable device may comprise a display. The head-wearable device may comprise a housing assembly. The housing assembly may include a rim surrounding the display, and a temple, rotatably coupled to the rim, comprising a sidewall, and supported by an ear of a user when the head-wearable device is worn by the user. The head-wearable device may comprise a printed circuit board (PCB) disposed in the temple. The head-wearable device may comprise one or more electronic components disposed on the PCB. The head-wearable device may comprise a first heat dissipation sheet, facing the PCB, disposed on a first portion of the sidewall, and configured to dissipate heat caused from the one or more electronic components. The head-wearable device may comprise a second heat dissipation sheet, spaced apart from the first heat dissipation sheet, disposed on a second portion of the sidewall. The head-wearable device may comprise a speaker, spaced apart from the PCB, attached to the sidewall through an adhesive on the sidewall, and disposed over the second portion of the sidewall and a third portion of the sidewall. A portion of the adhesive may be disposed on the third portion of the sidewall to seal a periphery of the speaker. The third portion of the sidewall may be positioned between the first portion of the sidewall and the second portion of the sidewall. The head-wearable device may comprise a third heat dissipation sheet, thermally connecting the first heat dissipation sheet and the second heat dissipation sheet. The third heat dissipation sheet may include a first portion, disposed on the sidewall of the temple, contacted with the first heat dissipation sheet, a second portion, disposed on the sidewall of the temple, contacted with the second heat dissipation sheet, and a third portion, extending from the first portion of the third heat dissipation sheet to the second portion of the third heat dissipation sheet, disposed in the third portion of the sidewall.

### [Description of the Drawings]

FIG. 1 is a block diagram of an electronic device in a network environment according to an embodiment.
FIG. 2 illustrates an example of a perspective view of a wearable device according to an embodiment.
FIG. 3 illustrates one or more hardware disposed in a wearable device according to an embodiment.
FIGS. 4 and 5 illustrate an exterior of a wearable device according to an embodiment.
FIG. 6 is a perspective view of a head-wearable device according to an embodiment.
FIG. 7 is an exploded view of a head-wearable device according to an embodiment.
FIG. 8 is a portion of a perspective view of a first temple in which a first cover plate is omitted.
FIG. 9 is a perspective view including a cross-section of a first temple of FIG. 8 cut along line A-A'.
FIG. 10 is a portion of a perspective view of a first temple in which a first sidewall is omitted.
FIG. 11 illustrates a first temple in which a printed circuit board, a first speaker, and a first cover plate are omitted.
FIG. 12 illustrates a first temple in which heat dissipation sheets and a first adhesive are disposed.
FIG. 13 illustrates a first temple in which a first cover plate is omitted.
FIG. 14 is a cross-sectional view of a first temple of FIG. 13 cut along line B-B'.
FIG. 15 illustrates the inside of a first temple according to an embodiment in which a printed circuit board and a first speaker are omitted.
FIGS. 16A and 16B are cross-sectional views of a first temple according to an embodiment.
FIG. 17 is a perspective view of a third heat dissipation sheet according to an embodiment.
FIG. 18 illustrates a first temple including a recess.
FIG. 19 illustrates a third heat dissipation sheet including a protrusion.
FIG. 20 illustrates a first temple in which a third heat dissipation sheet including a protrusion is disposed.
FIG. 21 and FIG. 22 illustrate a second temple.

### [Mode for Invention]

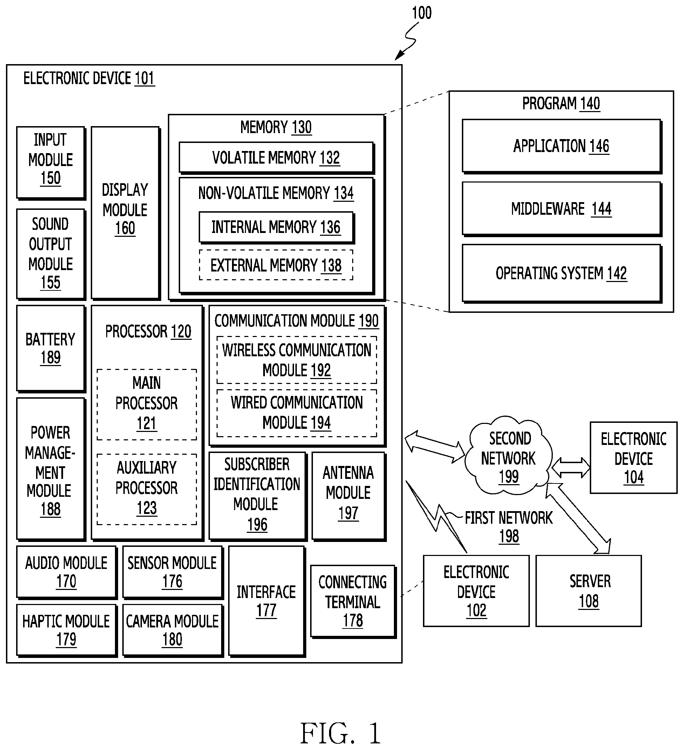

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

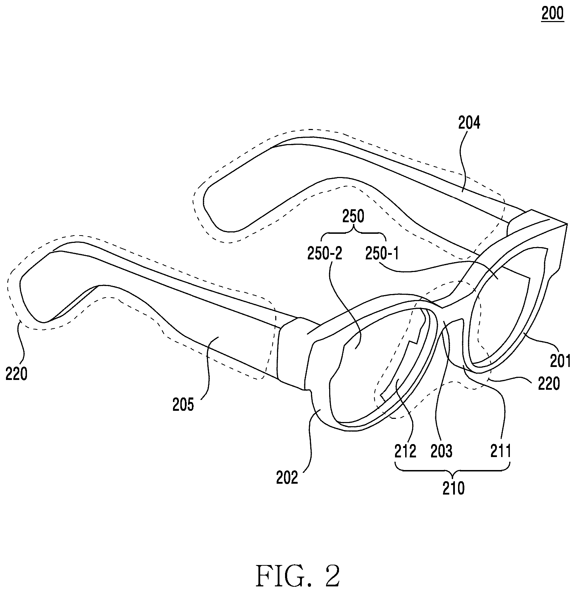

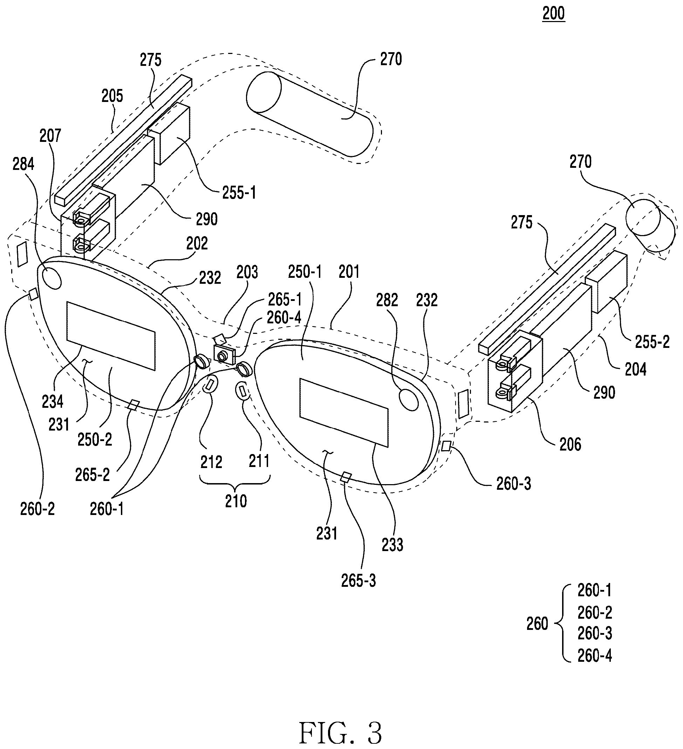

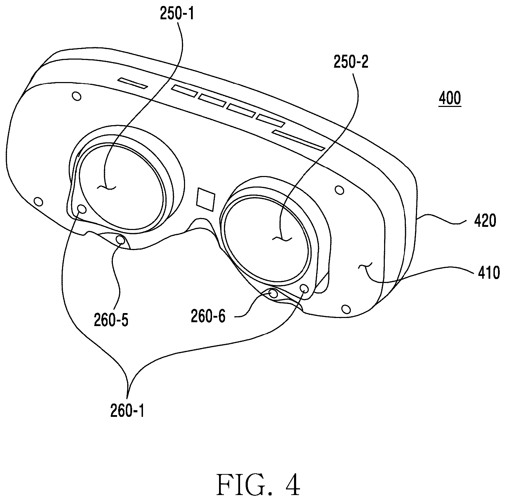

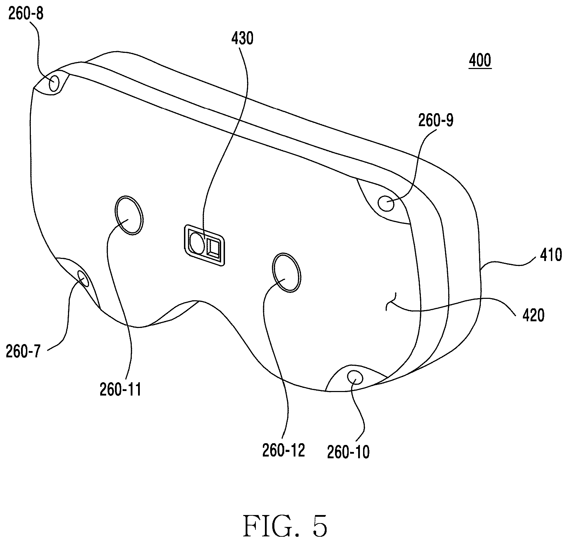

According to an embodiment, the electronic device 101 may include a wearable device. For example, the electronic device 101 may include a head-mounted display (HMD) that is wearable on a user's head. The electronic device 101 may be referred to as a head-mounted display (HMD) device, a head gear electronic device, a glasses-type (or a goggle-type) electronic device, a video see-through (or a visible see-through) (VST) device, an extended reality (XR) device, a virtual reality (VR) device, and/or an augmented reality (AR) device. For example, the electronic device 101 may include an accessory (e.g., a strap) to be attached to the user's head. An example of a hardware configuration included in the electronic device 101 is described below. In a wearable device (e.g., a wearable device 200 of FIG. 2) illustrated in FIGS. 2 and 3, an external shape of the wearable device having a shape of glasses is illustrated, but an embodiment is not limited thereto. An example of a structure of a wearable device (e.g., a wearable device 400 of FIG. 4) wearable on the user's head is described below with reference to FIGS. 4 and 5.

FIG. 2 illustrates an example of a perspective view of a wearable device according to an embodiment. FIG. 3 illustrates one or more hardware disposed in a wearable device according to an embodiment.

According to an embodiment, a wearable device 200 may have a shape of glasses that is wearable on a user's body part (e.g., a head). The wearable device 200 may include a head-mounted display (HMD). For example, a housing of the wearable device 200 may include a flexible material, such as rubber and/or silicone having a shape that is closely contacted with a portion of a user's head (e.g., a portion of a face surrounding both eyes). For example, the housing of the wearable device 200 may include one or more straps able to be twined around the user's head and/or one or more temples attachable to an ear of the head. The housing of the wearable device 200 may comprise one or more temples, and each temple may be an arm, protuberance, or other member which extends from the wearable device 200 and which is arranged to sit proximate to the user when the wearable device is worn.

Referring to FIG. 2, according to an embodiment, the wearable device 200 may include at least one display 250 and a frame supporting the at least one display 250.

According to an embodiment, the wearable device 200 may be wearable on a portion of the user's body. The wearable device 200 may provide augmented reality (AR), virtual reality (VR), or mixed reality (MR) combining the augmented reality and the virtual reality to a user wearing the wearable device 200. For example, the wearable device 200 may display a virtual reality image provided from at least one optical device 282 and 284 of FIG. 3 on at least one display 250, in response to a user's preset gesture obtained through a motion recognition camera 260-2 and 260-3 of FIG. 3.

According to an embodiment, the at least one display 250 may provide visual information to a user. For example, the at least one display 250 may include a transparent or translucent lens. The at least one display 250 may include a first display 250-1 and/or a second display 250-2 spaced apart from the first display 250-1. For example, the first display 250-1 and the second display 250-2 may be disposed at positions corresponding to the user's left and right eyes, respectively.

Referring to FIG. 3, the at least one display 250 may provide visual information transmitted through a lens included in the at least one display 250 from ambient light to a user and other visual information distinguished from the visual information. The lens may be formed based on at least one of a fresnel lens, a pancake lens, or a multi-channel lens. For example, the at least one display 250 may include a first surface 231 and a second surface 232 opposite to the first surface 231. A display area may be formed on the second surface 232 of at least one display 250. When the user wears the wearable device 200, ambient light may be transmitted to the user by being incident on the first surface 231 and being penetrated through the second surface 232. For another example, the at least one display 250 may display an augmented reality image in which a virtual reality image provided by the at least one optical device 282 and 284 is combined with a reality screen transmitted through ambient light, on a display area formed on the second surface 232.

According to an embodiment, the at least one display 250 may include at least one waveguide 233 and 234 that transmits light transmitted from the at least one optical device 282 and 284 by diffracting to the user. The at least one waveguide 233 and 234 may be formed based on at least one of glass, plastic, or polymer. A nano pattern may be formed on at least a portion of the outside or inside of the at least one waveguide 233 and 234. The nano pattern may be formed based on a grating structure having a polygonal or curved shape. Light incident to an end of the at least one waveguide 233 and 234 may be propagated to another end of the at least one waveguide 233 and 234 by the nano pattern. The at least one waveguide 233 and 234 may include at least one of at least one diffraction element (e.g., a diffractive optical element (DOE), a holographic optical element (HOE)), and a reflection element (e.g., a reflection mirror). For example, the at least one waveguide 233 and 234 may be disposed in the wearable device 200 to guide a screen displayed by the at least one display 250 to the user's eyes. For example, the screen may be transmitted to the user's eyes based on total internal reflection (TIR) generated in the at least one waveguide 233 and 234.

The wearable device 200 may analyze an object included in a real image collected through a photographing camera 260-4, combine with a virtual object corresponding to an object that become a subject of augmented reality provision among the analyzed object, and display on the at least one display 250. The virtual object may include at least one of text and images for various information associated with the object included in the real image. The wearable device 200 may analyze the object based on a multi-camera such as a stereo camera. For the object analysis, the wearable device 200 may execute space recognition (e.g., simultaneous localization and mapping (SLAM)) using the multi-camera and/or time-of-flight (ToF). The user wearing the wearable device 200 may watch an image displayed on the at least one display 250.

According to an embodiment, a frame may be configured with a physical structure in which the wearable device 200 may be worn on the user's body. According to an embodiment, the frame may be configured so that when the user wears the wearable device 200, the first display 250-1 and the second display 250-2 may be positioned corresponding to the user's left and right eyes. The frame may support the at least one display 250. For example, the frame may support the first display 250-1 and the second display 250-2 to be positioned at positions corresponding to the user's left and right eyes.

Referring to FIG. 2, according to an embodiment, the frame may include an area 220 at least partially in contact with the portion of the user's body in case that the user wears the wearable device 200. For example, the area 220 of the frame in contact with the portion of the user's body may include an area in contact with a portion of the user's nose, a portion of the user's ear, and a portion of the side of the user's face that the wearable device 200 contacts. According to an embodiment, the frame may include a nose pad 210 that is contacted on the portion of the user's body. When the wearable device 200 is worn by the user, the nose pad 210 may be contacted on the portion of the user's nose. The frame may include a first temple 204 and a second temple 205, which are contacted on another portion of the user's body that is distinct from the portion of the user's body.

For example, the frame may include a first rim 201 surrounding at least a portion of the first display 250-1, a second rim 202 surrounding at least a portion of the second display 250-2, a bridge 203 disposed between the first rim 201 and the second rim 202, a first pad 211 disposed along a portion of the edge of the first rim 201 from one end of the bridge 203, a second pad 212 disposed along a portion of the edge of the second rim 202 from the other end of the bridge 203, the first temple 204 extending from the first rim 201 and fixed to a portion of the wearer's ear, and the second temple 205 extending from the second rim 202 and fixed to a portion of the ear opposite to the ear. The first pad 211 and the second pad 212 may be in contact with the portion of the user's nose, and the first temple 204 and the second temple 205 may be in contact with a portion of the user's face and the portion of the user's ear. The temples 204 and 205 may be rotatably connected to the rim through hinge units 206 and 207 of FIG. 3. The first temple 204 may be rotatably connected with respect to the first rim 201 through the first hinge unit 206 disposed between the first rim 201 and the first temple 204. The second temple 205 may be rotatably connected with respect to the second rim 202 through the second hinge unit 207 disposed between the second rim 202 and the second temple 205. According to an embodiment, the wearable device 200 may identify an external object (e.g., a user's fingertip) touching the frame and/or a gesture performed by the external object by using a touch sensor, a grip sensor, and/or a proximity sensor formed on at least a portion of the surface of the frame.

According to an embodiment, the wearable device 200 may include hardware (e.g., hardware described above based on the block diagram of FIG. 2) that performs various functions. For example, the hardware may include a battery module 270, an antenna module 275, the at least one optical device 282 and 284, speakers (e.g., speakers 255-1 and 255-2), a microphone (e.g., microphones 265-1, 265-2, and 265-3), a light emitting module, and/or a printed circuit board (PCB) 290 (e.g., printed circuit board). Various hardware may be disposed in the frame.

According to an embodiment, the microphone (e.g., the microphones 265-1, 265-2, and 265-3) of the wearable device 200 may obtain a sound signal, by being disposed on at least a portion of the frame. The first microphone 265-1 disposed on the bridge 203, the second microphone 265-2 disposed on the second rim 202, and the third microphone 265-3 disposed on the first rim 201 are illustrated in FIG. 3, but the number and disposition of the microphone 265 are not limited to an embodiment of FIG. 3. In case that the number of the microphone 265 included in the wearable device 200 is two or more, the wearable device 200 may identify a direction of the sound signal by using a plurality of microphones disposed on different portions of the frame.

According to an embodiment, the at least one optical device 282 and 284 may project a virtual object on the at least one display 250 in order to provide various image information to the user. For example, the at least one optical device 282 and 284 may be a projector. The at least one optical device 282 and 284 may be disposed adjacent to the at least one display 250 or may be included in the at least one display 250 as a portion of the at least one display 250. According to an embodiment, the wearable device 200 may include a first optical device 282 corresponding to the first display 250-1, and a second optical device 284 corresponding to the second display 250-2. For example, the at least one optical device 282 and 284 may include the first optical device 282 disposed at a periphery of the first display 250-1 and the second optical device 284 disposed at a periphery of the second display 250-2. The first optical device 282 may transmit light to the first waveguide 233 disposed on the first display 250-1, and the second optical device 284 may transmit light to the second waveguide 234 disposed on the second display 250-2.

In an embodiment, a camera 260 may include the photographing camera 260-4, an eye tracking camera (ET CAM) 260-1, and/or the motion recognition camera 260-2 and 260-3. The photographing camera 260-4, the eye tracking camera 260-1, and the motion recognition camera 260-2 and 260-3 may be disposed at different positions on the frame and may perform different functions. The eye tracking camera 260-1 may output data indicating a position of eye or a gaze of the user wearing the wearable device 200. For example, the wearable device 200 may detect the gaze from an image including the user's pupil obtained through the eye tracking camera 260-1.

The wearable device 200 may identify an object (e.g., a real object, and/or a virtual object) focused by the user, by using the user's gaze obtained through the eye tracking camera 260-1. The wearable device 200 identifying the focused object may execute a function (e.g., gaze interaction) for interaction between the user and the focused object. The wearable device 200 may represent a portion corresponding to eye of an avatar indicating the user in the virtual space, by using the user's gaze obtained through the eye tracking camera 260-1. The wearable device 200 may render an image (or a screen) displayed on the at least one display 250, based on the position of the user's eye.

For example, visual quality (e.g., resolution, brightness, saturation, grayscale, and PPI) of a first area related to the gaze within the image and visual quality of a second area distinguished from the first area may be different. The wearable device 200 may obtain an image having the visual quality of the first area matching the user's gaze and the visual quality of the second area by using foveated rendering. For example, when the wearable device 200 supports an iris recognition function, user authentication may be performed based on iris information obtained using the eye tracking camera 260-1. An example in which the eye tracking camera 260-1 is disposed toward the user's right eye is illustrated in FIG. 3, but the embodiment is not limited thereto, and the eye tracking camera 260-1 may be disposed alone toward the user's left eye or may be disposed toward two eyes.

In an embodiment, the photographing camera 260-4 may photograph a real image or background to be matched with a virtual image in order to implement the augmented reality or mixed reality content. The photographing camera 260-4 may be used to obtain an image having a high resolution based on a high resolution (HR) or a photo video (PV). The photographing camera 260-4 may photograph an image of a specific object existing at a position viewed by the user and may provide the image to the at least one display 250. The at least one display 250 may display one image in which a virtual image provided through the at least one optical device 282 and 284 is overlapped with information on the real image or background including an image of the specific object obtained by using the photographing camera 260-4. The wearable device 200 may compensate for depth information (e.g., a distance between the wearable device 200 and an external object obtained through a depth sensor), by using an image obtained through the photographing camera 260-4. The wearable device 200 may perform object recognition through an image obtained using the photographing camera 260-4. The wearable device 200 may perform a function (e.g., auto focus) of focusing an object (or subject) within an image and/or an optical image stabilization (OIS) function (e.g., an anti-shaking function) by using the photographing camera 260-4. While displaying a screen representing a virtual space on the at least one display 250, the wearable device 200 may perform a pass through function for displaying an image obtained through the photographing camera 260-4 overlapping at least a portion of the screen. In an embodiment, the photographing camera 260-4 may be disposed on the bridge 203 disposed between the first rim 201 and the second rim 202.

The eye tracking camera 260-1 may implement a more realistic augmented reality by matching the user's gaze with the visual information provided on the at least one display 250, by tracking the gaze of the user wearing the wearable device 200. For example, when the user looks at the front, the wearable device 200 may naturally display environment information associated with the user's front on the at least one display 250 at a position where the user is positioned. The eye tracking camera 260-1 may be configured to capture an image of the user's pupil in order to determine the user's gaze. For example, the eye tracking camera 260-1 may receive gaze detection light reflected from the user's pupil and may track the user's gaze based on the position and movement of the received gaze detection light. In an embodiment, the eye tracking camera 260-1 may be disposed at a position corresponding to the user's left and right eyes. For example, the eye tracking camera 260-1 may be disposed in the first rim 201 and/or the second rim 202 to face the direction in which the user wearing the wearable device 200 is positioned.

The motion recognition camera 260-2 and 260-3 may provide a specific event to the screen provided on the at least one display 250 by recognizing the movement of the whole or portion of the user's body, such as the user's torso, hand, or face. The motion recognition camera 260-2 and 260-3 may obtain a signal corresponding to motion by recognizing the user's motion (e.g., gesture recognition), and may provide a display corresponding to the signal to the at least one display 250. The processor may identify a signal corresponding to the operation and may perform a preset function based on the identification. The motion recognition camera 260-2 and 260-3 may be used to perform simultaneous localization and mapping (SLAM) for 6 degrees of freedom pose (6 dof pose) and/or a space recognition function using a depth map. The processor may perform a gesture recognition function and/or an object tracking function, by using the motion recognition camera 260-2 and 260-3. In an embodiment, the motion recognition camera 260-2 and camera 260-3 may be disposed on the first rim 201 and/or the second rim 202.

The camera 260 included in the wearable device 200 is not limited to the above-described eye tracking camera 260-1 and the motion recognition camera 260-2 and 260-3. For example, the wearable device 200 may identify an external object included in the FoV by using a camera disposed toward the user's FoV. The wearable device 200 identifying the external object may be performed based on a sensor for identifying a distance between the wearable device 200 and the external object, such as a depth sensor and/or a time of flight (ToF) sensor. The camera 260 disposed toward the FoV may support an autofocus function and/or an optical image stabilization (OIS) function. For example, in order to obtain an image including a face of the user wearing the wearable device 200, the wearable device 200 may include the camera 260 (e.g., a face tracking (FT) camera) disposed toward the face.

Although not illustrated, the wearable device 200 according to an embodiment may further include a light source (e.g., LED) that emits light toward a subject (e.g., user's eyes, face, and/or an external object in the FoV) photographed by using the camera 260. The light source may include an LED having an infrared wavelength. The light source may be disposed on at least one of the frame, and the hinge units 206 and 207.

According to an embodiment, the battery module 270 may supply power to electronic components of the wearable device 200. In an embodiment, the battery module 270 may be disposed in the first temple 204 and/or the second temple 205. For example, the battery module 270 may be a plurality of battery modules 270. The plurality of battery modules 270, respectively, may be disposed on each of the first temple 204 and the second temple 205. In an embodiment, the battery module 270 may be disposed at an end of the first temple 204 and/or the second temple 205.

The antenna module 275 may transmit the signal or power to the outside of the wearable device 200 or may receive the signal or power from the outside. In an embodiment, the antenna module 275 may be disposed in the first temple 204 and/or the second temple 205. For example, the antenna module 275 may be disposed close to one surface of the first temple 204 and/or the second temple 205.

The speaker 255 may output a sound signal to the outside of the wearable device 200. A sound output module may be referred to as a speaker. In an embodiment, the speaker 255 may be disposed in the first temple 204 and/or the second temple 205 in order to be disposed adjacent to the ear of the user wearing the wearable device 200. For example, the speaker 255 may include a second speaker 255-2 disposed adjacent to the user's left ear by being disposed in the first temple 204, and a first speaker 255-1 disposed adjacent to the user's right ear by being disposed in the second temple 205.

The light emitting module (not illustrated) may include at least one light emitting element. The light emitting module may emit light of a color corresponding to a specific state or may emit light through an operation corresponding to the specific state in order to visually provide information on a specific state of the wearable device 200 to the user. For example, when the wearable device 200 requires charging, it may emit red light at a constant cycle. In an embodiment, the light emitting module may be disposed on the first rim 201 and/or the second rim 202.

Referring to FIG. 3, according to an embodiment, the wearable device 200 may include the printed circuit board (PCB) 290. The PCB 290 may be included in at least one of the first temple 204 or the second temple 205. The PCB 290 may include an interposer disposed between at least two sub PCBs. On the PCB 290, one or more hardware (e.g., hardware illustrated by blocks of FIG. 4) included in the wearable device 200 may be disposed. The wearable device 200 may include a flexible PCB (FPCB) for interconnecting the hardware.

According to an embodiment, the wearable device 200 may include at least one of a gyro sensor, a gravity sensor, and/or an acceleration sensor for detecting the posture of the wearable device 200 and/or the posture of a body part (e.g., a head) of the user wearing the wearable device 200. Each of the gravity sensor and the acceleration sensor may measure gravity acceleration, and/or acceleration based on preset 3-dimensional axes (e.g., x-axis, y-axis, and z-axis) perpendicular to each other. The gyro sensor may measure angular velocity of each of preset 3-dimensional axes (e.g., x-axis, y-axis, and z-axis). At least one of the gravity sensor, the acceleration sensor, and the gyro sensor may be referred to as an inertial measurement unit (IMU). According to an embodiment, the wearable device 200 may identify the user's motion and/or gesture performed to execute or stop a specific function of the wearable device 200 based on the IMU.

FIGS. 4 and 5 illustrate the appearance of a wearable device according to an embodiment.

In a wearable device 400 of FIGS. 4 to 5, the wearable device 200 described with reference to FIGS. 2 and/or 3 may include at least a part of hardware. According to an embodiment, an example of the exterior of a first surface 410 of a housing of the wearable device 400 may be illustrated in FIG. 4, and an example of the exterior of a second surface 420 opposite to the first surface 410 may be illustrated in FIG. 5.

Referring to FIG. 4, according to an embodiment, the first surface 410 of the wearable device 400 may have an attachable shape on the user's body part (e.g., the user's face). Although not illustrated, the wearable device 400 may further include a strap for being fixed on the user's body part, and/or one or more temples (e.g., the first temple 204 and/or the second temple 205 of FIGS. 2 to 4). A first display 250-1 for outputting an image to the left eye among the user's two eyes and a second display 250-2 for outputting an image to the right eye among the user's two eyes may be disposed on the first surface 410. The wearable device 400 may further include rubber or silicon packing, which are formed on the first surface 410, for preventing interference by light (e.g., ambient light) different from the light emitted from the first display 250-1 and the second display 250-2.

According to an embodiment, the wearable device 400 may include cameras 260-1 for photographing and/or tracking two eyes of the user adjacent to each of the first display 250-1 and the second display 250-2. The cameras 260-1 may be referred to as the gaze tracking camera 260-1 of FIG. 3. According to an embodiment, the wearable device 400 may include cameras 260-5 and 260-6 for photographing and/or recognizing the user's face. The cameras 260-5 and 260-6 may be referred to as an FT camera. The wearable device 400 may control an avatar representing a user in a virtual space, based on a motion of the user's face identified using the cameras 260-5 and 260-6. For example, the wearable device 400 may change a texture and/or a shape of a portion (e.g., a portion of an avatar representing a human face) of the avatar, by using information obtained by the cameras 260-5 and 260-6 (e.g., the FT camera) and representing the facial expression of the user wearing the wearable device 400.

Referring to FIG. 5, a camera (e.g., cameras 260-7, 260-8, 260-9, 260-10, 260-11, and 260-12), and/or a sensor (e.g., the depth sensor 330) for obtaining information associated with the external environment of the wearable device 400 may be disposed on the second surface 420 opposite to the first surface 410 of FIG. 4. For example, the cameras 260-7, 260-8, 260-9, and 260-10 may be disposed on the second surface 420 in order to recognize an external object. The cameras 260-7, 260-8, 260-9, and 260-10 may be referred to as the motion recognition cameras 260-2 and 260-3 of FIG. 3.

For example, by using cameras 260-11 and 260-12, the wearable device 400 may obtain an image and/or video to be transmitted to each of the user's two eyes. The camera 260-11 may be disposed on the second surface 420 of the wearable device 400 to obtain an image to be displayed through the second display 250-2 corresponding to the right eye among the two eyes. The camera 260-12 may be disposed on the second surface 420 of the wearable device 400 to obtain an image to be displayed through the first display 250-1 corresponding to the left eye among the two eyes. The cameras 260-11 and 260-12 may be referred to as the photographing camera 260-4 of FIG. 3.

According to an embodiment, the wearable device 400 may include the depth sensor 330 disposed on the second surface 420 in order to identify a distance between the wearable device 400 and the external object. By using the depth sensor 330, the wearable device 400 may obtain spatial information (e.g., a depth map) about at least a portion of the FoV of the user wearing the wearable device 400. Although not illustrated, a microphone for obtaining sound outputted from the external object may be disposed on the second surface 420 of the wearable device 400. The number of microphones may be one or more according to embodiments.

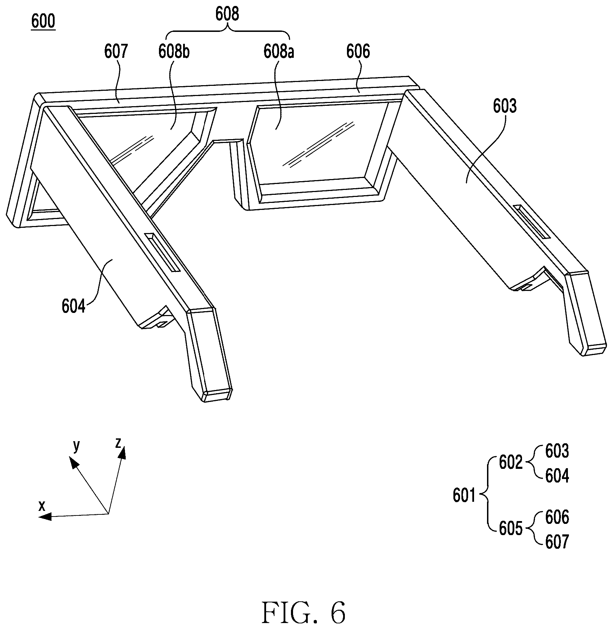

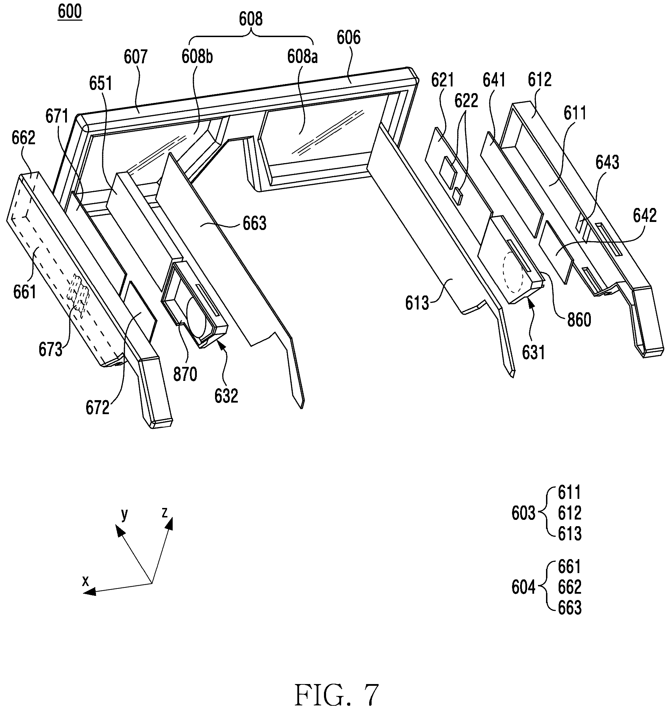

FIG. 6 is a perspective view of a head-wearable device according to an embodiment. FIG. 7 is an exploded view of a head-wearable device according to an embodiment.

According to an embodiment, a wearable device may be referred to as a head-wearable device 600 that may be worn on a user's head or face. Referring to FIG. 6, according to an embodiment, the head-wearable device 600 may include a housing assembly 601 and a display 608. The housing assembly 601 may define an exterior of the head-wearable device 600 and may accommodate electronic components to provide various functions of the head-wearable device 600.

According to an embodiment, the head-wearable device 600 may execute a function related to augmented reality (AR) and/or mixed reality (MR). For example, the head-wearable device 600 may include at least one lens disposed adjacent to a user's eye in a state of being worn by the user. The head-wearable device 600 may combine light passing through the lens with light emitted from the display 608. A display area of the display 608 may be formed in the lens through which the light passes. Since the head-wearable device 600 combines the light with the light emitted from the display 608, the user may see an image in which a real object, recognized by the light passing through the lens, and a virtual object, formed by the light emitted from the display 608, are mixed. The augmented reality, the mixed reality, and/or the virtual reality described above may be referred to as extended reality (XR). According to an embodiment, the head-wearable device 600 may execute a function related to a video see-through (or a visible see-through) (VST) and/or virtual reality (VR).

According to an embodiment, the display 608 may output visual information to the user of the head-wearing device 600. The display 608 may be arranged in front of the user's eye when the user wears the head-wearable device 600. For example, the display 608 may be controlled by a processor including circuitry such as a graphic processing unit (GPU) to output the visualized information to the user. The display 608 may include a flexible display, a flat panel display (FPD) and/or electronic paper. The display 608 may include a liquid crystal display (LCD), a plasma display panel (PDP), and/or one or more light emitting diodes (LEDs). The LED may include an organic LED (OLED). However, embodiments of the present disclosure are not limited thereto, and for example, in a case that the head-wearable device 600 includes a lens to transmit ambient light (or external light), the display 608 may include a projector (or a projection assembly) for projecting the light onto the lens. When the user wears the head-wearable device 600, pixels included in the display 608 may be disposed toward any one of user's two eyes. For example, the display 608 may include display areas (or active areas) corresponding to each of the user's two eyes. For example, the display 608 may include a first display 608a corresponding to a user's right eye and a second display 608b corresponding to a user's left eye. The second display 608b may be spaced apart from the first display 608a.

According to an embodiment, the housing assembly 601 may include a rim 605 at least partially surrounding the display 608. For example, the housing assembly 601 may include a first rim 606 at least partially surrounding the first display 608a and a second rim 607 at least partially surrounding the second display 608b.

According to an embodiment, the housing assembly 601 may include a housing part that is contacted with a portion of a user's body, and that supports the head-wearable device 600, when the head-wearable device 600 is worn by the user. For example, in a glasses-type device, the housing assembly 601 may include a temple 602 extending from the rim 605 and supported by an ear of the user. The temple 602 may include a first temple 603 rotatably coupled to the first rim 606 and a second temple 604 rotatably coupled to the second rim 607. The first temple 603 may extend from the first rim 606 and be supported by a user's right ear. The second temple 604 may extend from the second rim 607 and be supported by a user's left ear. The first temple 603 and the second temple 604 may each be contacted with the user's ear and may support the head-wearable device 600.

According to an embodiment, in the head-to-wearable device 600, the electronic components for various functions of the head-wearable device 600 may be disposed in the first temple 603 and the second temple 604. For example, speakers (e.g., a first speaker 631 and a second speaker 632 of FIG. 7) configured to provide audio signals may be accommodated in each of the first temple 603 and the second temple 604. For example, the first speaker 631 may be disposed in the first temple 603, and the second speaker 632 may be disposed in the second temple 604. The first temple 603 and the second temple 604 may include speaker holes to provide a path through which the audio signals provided from each of the speakers are emitted to the outside of the housing part (e.g., the temple 602) and port holes to improve quality of the audio signals.

Referring to FIG. 7, a printed circuit board 621 and the first speaker 631 may be disposed in the first temple 603. The first temple 603 may include a first sidewall 611, a first frame 612, and a first cover plate 613. The first frame 612 may surround a periphery of the first sidewall 611. The first cover plate 613 may define an inside space of the first temple 603 together with the first frame 612, by being coupled to the first frame 612. The inside space of the first temple 603 may be referred to as a space surrounded by the first sidewall 611, the first frame 612, and the first cover plate 613. The first speaker 631 and the printed circuit board 621 may be disposed in the inside space of the first temple 603.

According to an embodiment, the printed circuit board 621 may include a plurality of conductive layers and a plurality of non-conductive layers alternately stacked with the plurality of conductive layers. The printed circuit board 621 may provide an electrical connection between various electronic components using wires and conductive vias formed on the plurality of conductive layers. According to an embodiment, one or more electronic components 622 may be disposed on the printed circuit board 621. For example, a processor (e.g., the processor 120 of FIG. 1) to control an overall operation of the head-wearable device 600 and/or wireless communication circuitry (e.g., the wireless communication module 192 of FIG. 1) for wireless communication with an external electronic device may be disposed on the printed circuit board 621. In addition, various electronic components may be disposed on the printed circuit board 621.

According to an embodiment, the first speaker 631 may be disposed on the first sidewall 611 of the first temple 603. For example, the first speaker 631 may be attached to the first sidewall 611 through a first adhesive 860 interposed between the first speaker 631 and the first sidewall 611. The first adhesive 860 may be disposed along a periphery of the first speaker 631. According to an embodiment, the first speaker 631 may be spaced apart from the printed circuit board 621.

According to an embodiment, a second speaker 632 may be disposed on a second sidewall 661 of a second temple 604. For example, the second speaker 632 may be attached to the second sidewall 661 through a second adhesive 870 interposed between the second speaker 632 and the second sidewall 661. The second adhesive 870 may be disposed along a periphery of the second speaker 632. According to an embodiment, the second speaker 632 may be spaced apart from a battery 651.

The one or more electronic components 622 and the first speaker 631 may be configured to operate based on power provided from the battery 651. When the one or more electronic components 622 and the first speaker 631 operate, heat may be caused by resistance included in the one or more electronic components 622 and the first speaker 631. When the heat from the one or more electronic components 622 and the first speaker 631 remains in a localized area, temperature of the inside space of the first temple 603 may increase. The temperature increase may cause damage or malfunction of the one or more electronic components 622 and the first speaker 631. For example, while the processor is controlling an operation of the head-wearable device 600, heat may be emitted from the processor. The heat may cause damage or malfunction of the head-wearable device 600, by causing a temperature increase in the processor or an electronic component disposed around the processor.

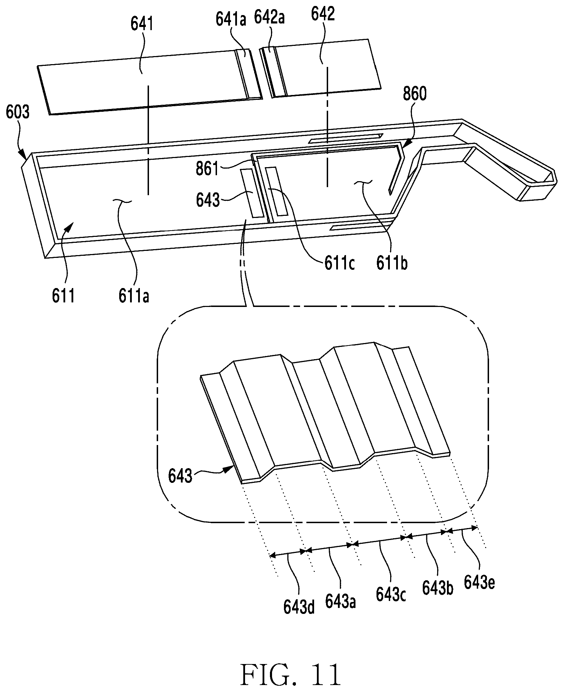

According to an embodiment, the head-wearable device 600 may include heat dissipation sheets for dissipating heat caused from the one or more electronic components 622 and a speaker. The head-wearable device 600 may include a first heat dissipation sheet 641, a second heat dissipation sheet 642, and a third heat dissipation sheet 643 disposed in the first temple 603. Although the first, second and third heat dissipation sheets are described herein as sheets they are not limited to such, and have a shape other than that of a sheet. The first heat dissipation sheet may be a first heat dissipation member. The second heat dissipation sheet may be a second heat dissipation member. The third heat dissipation sheet may be a third heat dissipation member. The first heat dissipation sheet 641 may be disposed on a portion (e.g., the first portion 611a of FIG. 11) of the first sidewall 611 to face the printed circuit board 621. The second heat dissipation sheet 642 may be disposed on another portion (e.g., the second portion 611b of FIG. 11) of the first sidewall 611 on which a speaker is disposed. The first speaker 631 may be disposed over the second portion 611b of the first sidewall 611. A structure in which the first speaker 631 is disposed "over" the second portion 611b of the first sidewall 611 should be understood as indicating a relative positional relationship between the first speaker 631 and the second portion 611b, other than indicating an absolute positional relationship between the first speaker 631 and the second portion 611b. For example, in a drawing illustrated in FIG. 7, the first speaker 631 being disposed over the second portion 611b may be referred to as the first speaker 631 being positioned in a +x direction of the first sidewall 611.

According to an embodiment, the battery 651 and the second speaker 632 may be disposed in the second temple 604. Descriptions of a structure of the first temple 603 may be substantially identically applied to the second temple 604. For example, a structure of the second temple 604 may be substantially identical to the structure of the first temple 603. The second temple 604 may include the second sidewall 661, a second frame 662, and a second cover plate 663 defining an inside space of the second temple 604. The second frame 662 may surround a periphery of the second sidewall 661. The second cover plate 663 may define the inside space of the second temple 604 together with the second frame 662, by being coupled to the second frame 662. The inside space of the second temple 604 may be referred to as a space surrounded by the second sidewall 661, the second frame 662, and the second cover plate 663. The second speaker 632 and the battery 651 may be disposed in the inside space of the second temple 604.

According to an embodiment, a fourth heat dissipation sheet 671, a fifth heat dissipation sheet 672, and a sixth heat dissipation sheet 673 to dissipate heat caused from the battery 651 and the second speaker 632 may be included. The fourth heat dissipation sheet 671 may correspond to the first heat dissipation sheet 641. The fifth heat dissipation sheet 672 may correspond to the second heat dissipation sheet 642. The sixth heat dissipation sheet 673 may correspond to the third heat dissipation sheet 643.

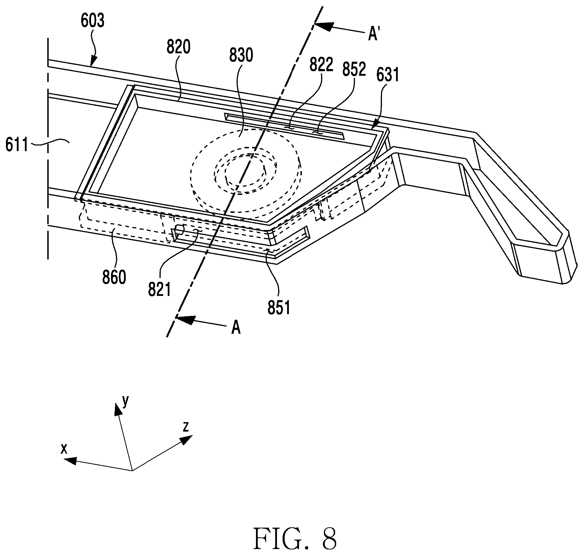

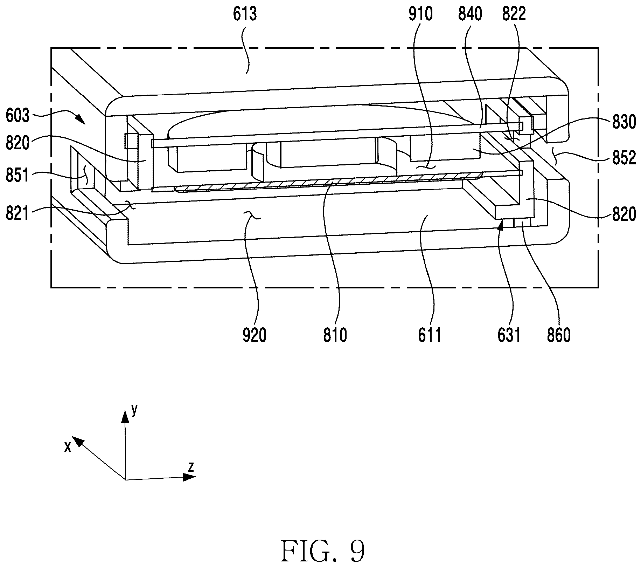

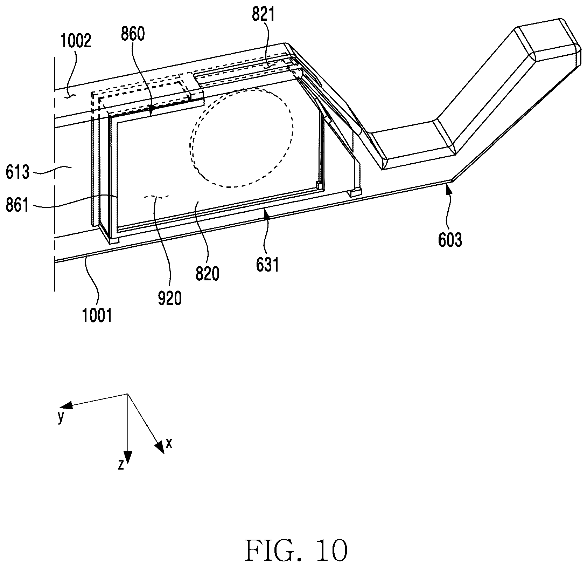

FIG. 8 is a portion of a perspective view of a first temple in which a first cover plate is omitted. FIG. 9 is a perspective view including a cross-section of a first temple of FIG. 8 cut along line A-A'. FIG. 10 is a portion of a perspective view of a first temple in which a first sidewall is omitted.

Descriptions of a first speaker 631 and a first temple 603 described below may be substantially identically applied to a second speaker (e.g., the second speaker 632 of FIG. 7) and a second temple (e.g., the second temple 604 of FIG. 7).

Referring to FIG. 8, the first temple 603 may include a second speaker hole 851 and a second port hole 852 for audio signals provided from the first speaker 631. The second speaker hole 851 may be aligned with a first speaker hole 821 to be described below and provide a path through which the audio signals are transmitted to the outside of the first temple 603. For example, the first speaker hole 821 may be connected to a front chamber (e.g., a front chamber 920 of FIG. 920) formed in front of a diaphragm 810 through the second speaker hole 851. A first enclosure 820 may include a first port hole 822. To improve quality of the audio signals, the first port hole 822 may be connected to a rear chamber (e.g., a rear chamber 910 of FIG. 9) formed at a rear of the diaphragm 810.

According to an embodiment, the first speaker 631 may be attached to a first sidewall 611 and the first cover plate (e.g., the first cover plate 613 of FIG. 7) through an adhesive. For example, the first cover plate 613 may be adjacent to the rear chamber 910 formed at the rear of diaphragm 810 and the first sidewall 611 may be close to the front chamber 920 formed in front of the diaphragm 810. The first speaker 631 may be attached onto the first sidewall 611 through a first adhesive 860. For example, the first enclosure 820 surrounding components of the first speaker 631 may be attached onto the first sidewall 611 through the first adhesive 860.

Referring to FIG. 9, the first speaker 631 may include the diaphragm 810, the first enclosure 820, a permanent magnet 830, and a yoke 840.

According to an embodiment, the diaphragm 810 may be configured to convert electrical signals into audio signals. The diaphragm 810 may be configured to generate audio signals by vibrating based on electrical signals. The permanent magnet 830 may be configured to cause a vibration of the diaphragm 810. The yoke 840 may fix the permanent magnet 830 and collect a force of a magnetic field generated by the permanent magnet 830 to increase an output and/or efficiency of the first speaker 631. The first enclosure 820, which is a component defining an exterior of the first speaker 631, may enclose the diaphragm 810, the permanent magnet 830, and the yoke 840.

According to an embodiment, the audio signals generated from the diaphragm 810 may resonate in a rear chamber 910 in the first enclosure 820. The rear chamber 910 in the first enclosure 820 may be referred to as a resonance space. The audio signals generated from the diaphragm 810 may be amplified at a resonance frequency based on a volume of the resonance space in the first enclosure 820. The first enclosure 820 may be connected to the rear chamber 910 and include the first port hole 822 through which air in the rear chamber 910 may flow. The first port hole 822 may be aligned with the second port hole 852 of the first temple 603. As the air in the rear chamber 910 flows through the first port hole 822 and the second port hole 852, low-frequency sound of audio signals may be enhanced.

According to an embodiment, the first enclosure 820 may include the first speaker hole 821 providing a path through which the audio signals generated from the diaphragm 810 are transmitted to the outside of the first speaker 631. The first speaker hole 821 may be aligned with the second speaker hole 851 of the first temple 603. The vibration of the diaphragm 810 may cause a vibration of air in the front chamber 920, and audio signals generated by the vibration may be provided to the outside of the head-wearable device (e.g., the head-to-wearable device 600 of FIG. 6) through the first speaker hole 821 and the second speaker hole 851. In a case that the front chamber 920 is not sealed at another portion except for the first speaker hole 821, audio signals may be distorted and quality of the audio signals may be deteriorated. For sealing of the front chamber 920, the first adhesive 860 may seal a periphery of the first enclosure 820.

Referring to FIG. 10, the first speaker 631 may be attached to the first sidewall (e.g., the first sidewall 611 of FIG. 9) of the first temple 603 through the first adhesive 860. Since the first speaker 631 illustrated in FIG. 10 is disposed in the first temple 603, it may be disposed between the first sidewall 611 and the first cover plate 613. The first adhesive 860 may be interposed between the first enclosure 820 of the first speaker 631 and the first sidewall 611 and attach the first speaker 631 to the first sidewall 611. The first adhesive 860 may seal the front chamber 920 connected to the first speaker hole 821. For sealing of the front chamber 920, the first adhesive 860 may be disposed to seal a periphery of the first speaker 631. For example, in FIG. 10, the first adhesive 860 may seal the front chamber 920 connected to the first speaker hole 821 by being disposed to form a closed loop.

A head-wearable device 600 may include a heat dissipation sheet. A heat dissipation sheet to dissipate heat caused from one or more electronic components (e.g., the one or more electronic components 622 of FIG. 7) disposed on a printed circuit board (e.g., the printed circuit board 621 of FIG. 7) may be configured to diffuse the heat in the first temple 603 such that the heat is not concentrated in a localized area. The heat diffused to an entire area of the first temple 603 may be emitted to the outside of the first temple 603. In a case that the heat dissipation sheet is disposed to entirely cover the first sidewall 611 to diffuse the heat to the entire area of the first temple 603, the heat dissipation sheet and the adhesive may overlap. Since the heat dissipation sheet is formed from heat dissipating materials to diffuse the heat, it may be difficult for the adhesive to be firmly attached to the heat dissipation sheet. Since a step portion of the adhesive may be formed, in a case that the adhesive includes a portion overlapping the heat dissipation sheet and a portion not overlapping the heat dissipation sheet, it may be difficult for the adhesive to be firmly attached to the heat dissipation sheet. Since the adhesive is easily detached from the heat dissipation sheet, sealing of an inside space of the first enclosure 820 may be difficult. In a case that the inside space of the first enclosure 820 is not properly sealed, audio signals provided from the first speaker 631 may be distorted and quality of the audio signals may be deteriorated.

According to an embodiment, in order for the first adhesive 860 to seal a periphery of the first speaker 631, a portion 861 of the first adhesive 860 may extend perpendicularly to an extension direction (e.g., a y-axis direction of FIG. 10) of the first temple 603. For example, the portion 861 of the first adhesive 860 may extend in a direction from an upper surface 1001 of the first temple 603 toward a lower surface 1002. A heat dissipation sheet to dissipate and diffuse heat of electronic components disposed in the first temple 603 may extend parallel to the extension direction of the first temple 603 to entirely diffuse the heat in the first temple 603. Since the heat dissipation sheet extends parallel to the extension direction of the first temple 603, and the portion 861 of the first adhesive 860 extends perpendicularly to the extension direction of the first temple 603, the heat dissipation sheet and the first adhesive 860 may overlap in a case that the heat dissipation sheet is formed as a single segment.

According to an embodiment, the head-wearable device 600 may include heat dissipation sheets separated from each other. As the heat dissipation sheets are separated from each other, the portion 861 of the first adhesive 860 extending perpendicularly to the extension direction of the first temple 603 and the heat dissipation sheets may not overlap each other. According to an embodiment, a first heat dissipation sheet (e.g., the first heat dissipation sheet 641 of FIG. 7), a second heat dissipation sheet (e.g., the second heat dissipation sheet 642 of FIG. 7), and a third heat dissipation sheet (e.g., the third heat dissipation sheet 643 of FIG. 7) may be disposed in the first temple 603. The first heat dissipation sheet 641, the second heat dissipation sheet 642, and the third heat dissipation sheet 643 may diffuse heat caused from the one or more electronic components 622 and the speaker inside the first temple 603 and provide the sealing of the inside space of the first enclosure 820.

Hereinafter, detailed structures of the first heat dissipation sheet 641, the second heat dissipation sheet 642, and the third heat dissipation sheet 643 are described with reference to the drawings. Descriptions of the first heat dissipation sheet 641, the second heat dissipation sheet 642, and the third heat dissipation sheet 643 described below may be substantially identically applied to a fourth heat dissipation sheet (e.g., the fourth heat dissipation sheet 671 of FIG. 7), a fifth heat dissipation sheet (e.g., the fifth heat dissipation sheet 672 of FIG. 7), and a sixth heat dissipation sheet (e.g., the sixth heat dissipation sheet 673 of FIG. 7), respectively.

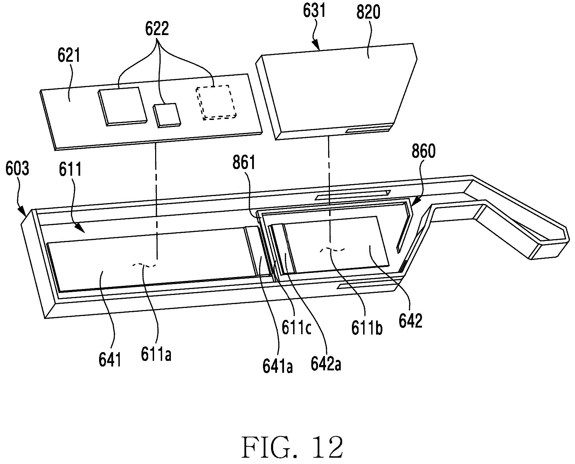

FIG. 11 illustrates a first temple in which a printed circuit board, a first speaker, and a first cover plate are omitted. FIG. 12 illustrates a first temple in which heat dissipation sheets and a first adhesive are disposed.

Referring to FIGS. 11 and 12, a first heat dissipation sheet 641 and a second heat dissipation sheet 642 may be spaced apart from each other. For example, the first heat dissipation sheet 641 and the second heat dissipation sheet 642 may not be formed integrally and may be separated from each other. The first heat dissipation sheet 641 may be disposed on a first portion 611a of a first sidewall 611. The second heat dissipation sheet 642 may be disposed on a second portion 611b of the first sidewall 611. When the first heat dissipation sheet 641 is disposed on the first portion 611a of the first sidewall 611 and the second heat dissipation sheet 642 is disposed on the second portion 611b of the first sidewall 611, the first heat dissipation sheet 641 and the second heat dissipation sheet 642 may be spaced apart from each other. The first heat dissipation sheet 641 may be disposed to face the printed circuit board (e.g., a printed circuit board 621 of FIG. 12). The second heat dissipation sheet 642 may be disposed to face the first speaker (e.g., a first speaker 631 of FIG. 12).

Since the first heat dissipation sheet 641 and the second heat dissipation sheet 642 are spaced apart from each other, heat caused from one or more electronic components (e.g., one or more electronic components 622 of FIG. 12) conducted through the first heat dissipation sheet 642 may be difficult to conduct to the second heat dissipation sheet 642, and heat caused from the first speaker 631 conducted through the second heat dissipation sheet 642 may be difficult to conduct to the first heat dissipation sheet 641. If the heat caused from the one or more electronic components 622 is diffused only to the first heat dissipation sheet 641, the heat may be difficult to diffuse to an entire inside space of a first temple 603. If the heat caused from the first speaker 631 is diffused only to the second heat dissipation sheet 642, the heat may be difficult to diffuse to the entire inside space of the first temple 603.

According to an embodiment, a third heat dissipation sheet 643 may be configured to thermally connect the first heat dissipation sheet 641 and the second heat dissipation sheet 642. As the third heat dissipation sheet 643 is physically contacted with each of the first heat dissipation sheet 641 and the second heat dissipation sheet 642, the first heat dissipation sheet 641 and the second heat dissipation sheet 642 may be thermally connected to each other through the third heat dissipation sheet 643.

For example, the heat caused from the one or more electronic components 622 disposed on the printed circuit board 621 may be transferred to the first heat dissipation sheet 641 facing the printed circuit board 621. The heat may be conducted to the second heat dissipation sheet 642 by being conducted along the first heat dissipation sheet 641 and the third heat dissipation sheet 643. Since the heat may diffuse along the first heat dissipation sheet 641, the second heat dissipation sheet 642, and the third heat dissipation sheet 643, the heat may be diffused to the entire inside space of the first temple 603 without being concentrated in a localized area (e.g., an area around the first portion 611a) in the first temple 603. Since the heat may be entirely diffused to the inside space of the first temple 603 and emitted to the outside of the first temple 603, the heat caused from the one or more electronic components 622 may be dissipated.

For example, the heat caused from the first speaker 631 may be transferred to the second heat dissipation sheet 642 facing the first speaker 631. The heat may be conducted to the first heat dissipation sheet 641 by being conducted along the second heat dissipation sheet 642 and the third heat dissipation sheet 643. Since the heat may diffuse along the first heat dissipation sheet 641, the second heat dissipation sheet 642, and the third heat dissipation sheet 643, the heat may be diffused to the entire inside space of the first temple 603 without being concentrated in a localized area (e.g., an area around the second portion 611b) in the first temple 603. The heat may be entirely diffused to the inside space of the first temple 603 and emitted to the outside of the first temple 603. The heat caused from the first speaker 631 may be dissipated.

According to an embodiment, a first adhesive 860 to attach the first speaker 631 to the first sidewall 611 may be disposed on the first sidewall 611. For example, the first adhesive 860 may seal a periphery of the first speaker 631 by being disposed along the periphery of the first speaker 631. The first adhesive 860 may include a portion 861 crossing a third portion 611c of the first sidewall 611 between a first portion 611a of the first sidewall 611 and a second portion 611b of the first sidewall 611 such that the first adhesive 860 may seal the periphery of the first speaker 631. The portion 861 of the first adhesive 860 may cross between the first heat dissipation sheet 641 and the second heat dissipation sheet 642.

According to an embodiment, a portion of the third heat dissipation sheet 643 may be inserted into the first sidewall 611, and another portion of the third heat dissipation sheet 643 may be disposed on the first sidewall 611. The other portion of the third heat dissipation sheet 643 disposed on the first sidewall 611 may be referred to as a portion of the third heat dissipation sheet 643 contacted with each of the first heat dissipation sheet 641 and the second heat dissipation sheet 642.

According to an embodiment, the third heat dissipation sheet 643 may include a first portion 643a, a second portion 643b, and a third portion 643c. The first portion 643a of the third heat dissipation sheet 643 may be a portion of the third heat dissipation sheet 643 contacted with the first heat dissipation sheet 641. The second portion 643b of the third heat dissipation sheet 643 may be a portion of the third heat dissipation sheet 643 contacted with the second heat dissipation sheet 642. The third portion 643c of the third heat dissipation sheet 643, which is a portion of the third heat dissipation sheet 643 extending from the first portion 643a of the third heat dissipation sheet 643 to the second portion 643b of the third heat dissipation sheet 643, may be disposed between the first portion 643a and the second portion 643b.

According to an embodiment, the first portion 643a of the third heat dissipation sheet 643 may be disposed to be exposed to the first sidewall 611 and may be contacted with the first heat dissipation sheet 641. For example, the first portion 643a of the third heat dissipation sheet 643 may be disposed on the first portion 611a of the first sidewall 611 on which the first heat dissipation sheet 641 is disposed, or may form substantially the same surface as the first sidewall 611. As a portion 641a of the first heat dissipation sheet 641 is disposed on the first portion 643a disposed in the first portion 611a, the first portion 643a of the third heat dissipation sheet 643 may be contacted with the first heat dissipation sheet 641. As the first portion 643a of the third heat dissipation sheet 643 contacts with the first heat dissipation sheet 641, the third heat dissipation sheet 643 may be thermally connected to the first heat dissipation sheet 641. The third heat dissipation sheet 643 may further include a fourth portion 643d extending from the first portion 643a of the third heat dissipation sheet 643 to be inserted into the first sidewall 611. The fourth portion 643d may be at least partially inserted into and fixed to the first portion 611a of the first sidewall 611.

According to an embodiment, the second portion 643b of the third heat dissipation sheet 643 may be disposed to be exposed to the first sidewall 611 and may be contacted with the second heat dissipation sheet 642. For example, the second portion 643b of the third heat dissipation sheet 643 may be disposed on the second portion 611b of the first sidewall 611 on which the second heat dissipation sheet 642 is disposed, or may form substantially the same surface as the first sidewall 611. As a portion 642a of the second heat dissipation sheet 642 is disposed on the first portion 643a disposed on the first portion 611a, the second portion 643b of the third heat dissipation sheet 643 may be contacted with the second heat dissipation sheet 642. As the second portion 643b of the third heat dissipation sheet 643 is contacted with the second heat dissipation sheet 642, the third heat dissipation sheet 643 may be thermally connected to the second heat dissipation sheet 642. The third heat dissipation sheet 643 may further include a fifth portion 643e extending from the second portion 643b of the third heat dissipation sheet 643 to be inserted into the first sidewall 611. The fifth portion 643e may be at least partially inserted into and fixed in the second portion 611b of the first sidewall 611.

According to an embodiment, the third portion 643c of the third heat dissipation sheet 643 may extend from the first portion 643a of the third heat dissipation sheet 643 to the second portion 643b of the third heat dissipation sheet 643. The third portion 643c of the third heat dissipation sheet 643 may be disposed in the third portion 611c of the first sidewall 611. The third portion 643c of the third heat dissipation sheet 643 may be separated from the first adhesive 860 by sidewall 611. The third portion 643c of the third heat dissipation sheet 643 may be substantially surrounded by the sidewall 611. For example, the third portion 643c of the third heat dissipation sheet 643 may extend between the first portion 643a and the second portion 643b to be inserted into the third portion 611c of the first sidewall 611. As the third portion 643c of the third heat dissipation sheet 643 is disposed in the third portion 611c of the first sidewall 611, the third portion 643c of the third heat dissipation sheet 643 may not be exposed on the first sidewall 611. For example, when the first temple 603 is viewed from above, the first portion 643a of the third heat dissipation sheet 643 and the second portion 643b of the third heat dissipation sheet 643 may be visible. When the first temple 603 is viewed from above, the fourth portion 643d of the third heat dissipation sheet 643, the fifth portion 643e of the third heat dissipation sheet 643, and the third portion 643c of the third heat dissipation sheet 643 may be disposed in the first sidewall 611 and may not be visible. The third heat dissipation sheet 643 may be fixed to the first sidewall 611 by the fourth portion 643d of the third heat dissipation sheet 643, the fifth portion 643e of the third heat dissipation sheet 643, and the third portion 643c of the third heat dissipation sheet 643 inserted into the first sidewall 611. The first portion 643a of the third heat dissipation sheet 643 may be positioned between the third portion 643c and the fourth portion 643d. The second portion 643b of the third heat dissipation sheet 643 may be positioned between the third portion 643c and the fifth portion 643e.

Referring to FIGS. 11 and 12, the first heat dissipation sheet 641 and the second heat dissipation sheet 642 may be disposed on the first sidewall 611 into which the third heat dissipation sheet (e.g., the third heat dissipation sheet 643 of FIG. 11) is partially inserted. When the first heat dissipation sheet 641 is disposed on the first portion 611a of the first sidewall 611, the first portion 643a of the third heat dissipation sheet 643 may be contacted with the portion 641a of the first heat dissipation sheet 641. When the second heat dissipation sheet 642 is disposed on the second portion 611b of the first sidewall 611, the second portion 643b of the third heat dissipation sheet 643 may be contacted with the portion 642a of the second heat dissipation sheet 642. Since the third heat dissipation sheet 643 contacts with both the first heat dissipation sheet 641 and the second heat dissipation sheet 642, the third heat dissipation sheet 643 may thermally connect the first heat dissipation sheet 641 and the second heat dissipation sheet 642.

Referring to FIG. 12, the printed circuit board 621 may be disposed to face the first heat dissipation sheet 641. The first speaker 631 may be disposed over the second portion 611b and the third portion 611c of the first sidewall 611. The first speaker 631 may be attached to the first sidewall 611 through the first adhesive 860.

According to an embodiment, a shape of the first adhesive 860 may correspond to a shape of a periphery of the first enclosure 820. Since the first speaker 631 is disposed over the second portion 611b and the third portion 611c of the first sidewall 611, the first adhesive 860 may be disposed to surround a portion of an outer periphery of the second heat dissipation sheet 642. As described below, the first enclosure 820 may include a first speaker hole 821 through which audio signals outputted from a diaphragm 810 of the first speaker 631 is emitted. The first adhesive 860 may be disposed to seal the periphery of the first speaker 631 (the first enclosure 820) to seal an inside space of an enclosure including the diaphragm 810. As described above, in a case that the first adhesive 860 contacts with the second heat dissipation sheet 642, the first adhesive 860 may detach from the second heat dissipation sheet 642 due to a characteristic of heat dissipating materials forming the second heat dissipation sheet 642. The first adhesive 860 may include a portion (e.g., the portion 861 of FIG. 11) disposed on the third portion 611c of the first sidewall 611 to seal the periphery of the first speaker 631 without contacting with the second heat dissipation sheet 642. The portion 861 of the first adhesive 860 may cross between the first portion (e.g., the first portion 643a of FIG. 11) and the second portion (e.g., the second portion 643b of FIG. 11) disposed on the first sidewall 611.

According to an embodiment, as the first heat dissipation sheet 641 and the second heat dissipation sheet 642 are separated, the first adhesive 860 may not contact with the first heat dissipation sheet 641 or the second heat dissipation sheet 642. Since the first adhesive 860 is spaced apart from the second heat dissipation sheet 642 disposed on the second portion 611b of the first sidewall 611, the first adhesive 860 may be directly attached to the first sidewall 611. As the third heat dissipation sheet 643 is not disposed on the third portion 611c of the first sidewall 611 and is inserted into the third portion 611c of the first sidewall 611, a portion (e.g., the portion 861 of FIG. 11) of the first adhesive 860 may be attached onto the third portion 611c of the first sidewall 611. As the first speaker 631 may be attached to the first sidewall 611 through the first adhesive 860 disposed not to contact with the first heat dissipation sheet 641 or the second heat dissipation sheet 642, the first speaker 631 may be firmly attached to the first sidewall 611. As the first adhesive 860 may be firmly attached to the first sidewall 611 since it does not include a portion overlapping the first heat dissipation sheet 641 or the second heat dissipation sheet 642, sealing of an inside space of the first speaker 631 may be stabilized.

According to an embodiment, the first temple 603 may be manufactured through a molding process. For example, as non-conductive materials are cured after the non-conductive materials forming the first temple 603 are injected into the inside of a mold having a shape corresponding to a shape of the first temple 603, the first temple 603 may be manufactured. The third heat dissipation sheet 643 may be partially positioned in the first sidewall 611 through an insert molding process when manufacturing the first temple 603. The third heat dissipation sheet 643 having a shape illustrated in FIG. 11 may be disposed in the mold, and injection materials may be injected into the mold. When the non-conductive materials are cured, the third heat dissipation sheet 643 including the third portion 643c inserted into the first sidewall 611 of the first temple 603 may be provided.

According to an embodiment, a material forming the third heat dissipation sheet 643 may be different from a material forming the first heat dissipation sheet 641 or the second heat dissipation sheet 642. For example, the third heat dissipation sheet 643 may be formed from a metal material. For example, the third heat dissipation sheet 643 may be formed from copper, but is not limited thereto. Since the third heat dissipation sheet 643 should maintain the shape illustrated in FIG. 11 while the first temple 603 is manufactured through the insert molding process, it may be formed from a metal material capable of maintaining the shape. The first heat dissipation sheet 641 and/or the second heat dissipation sheet 642 may be formed from a carbon-based heat dissipating material. For example, the first heat dissipation sheet 641 and/or the second heat dissipation sheet 642 may be formed from a graphite. Since a graphite has electrical insulation properties, it may be suitable as a material for dissipation of an electronic component such as the one or more electronic components 622 and the first speaker 631. Since weight of a graphite is lighter than weight of a metal, the first heat dissipation sheet 641 and/or the second heat dissipation sheet 642 may be formed from the graphite to reduce weight of a head-wearable device 600.

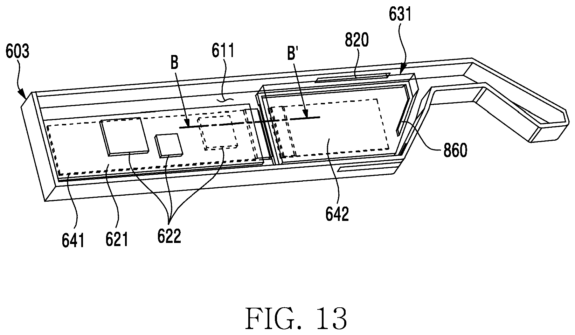

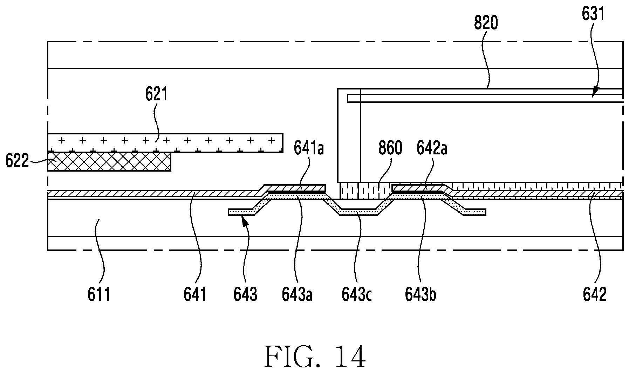

FIG. 13 illustrates a first temple in which a first cover plate is omitted. FIG. 14 is a cross-sectional view of a first temple of FIG. 13 cut along line B-B'.

Referring to FIG. 13, a first heat dissipation sheet 641 may face a printed circuit board 621. A second heat dissipation sheet 642 may face a first speaker 631. The first speaker 631 may be spaced apart from the printed circuit board 621. For example, a third heat dissipation sheet (e.g., the third heat dissipation sheet 643 of FIG. 11) thermally connecting the first heat dissipation sheet 641 and the second heat dissipation sheet 642 contacts with the first heat dissipation sheet 641 and the second heat dissipation sheet 642, and since a portion of the third heat dissipation sheet 643 is inserted into a first sidewall 611, when viewed from above, a first temple 603 may not be visible from the outside.

Referring to FIG. 14, the third heat dissipation sheet 643 may be configured to conduct heat caused from one or more electronic components 622 disposed on the printed circuit board 621 and transferred to the first heat dissipation sheet 641, to the second heat dissipation sheet 642 spaced apart from the first heat dissipation sheet 641.

According to an embodiment, heat may be emitted when the one or more electronic components 622 disposed on the printed circuit board 621 operate. The heat emitted from the one or more electronic components 622 may be transferred to the first heat dissipation sheet 641 facing the printed circuit board 621. The heat transferred to the first heat dissipation sheet 641 may be conducted along the first heat dissipation sheet 641. Since a portion 641a of the first heat dissipation sheet 641 contacts with a first portion 643a of the third heat dissipation sheet 643, the heat conducted along the first heat dissipation sheet 641 may be conducted to the third heat dissipation sheet 643. The heat conducted to the third heat dissipation sheet 643 may be conducted along the third heat dissipation sheet 643. For example, the heat conducted from the first heat dissipation sheet 641 to the third heat dissipation sheet 643 may be conducted from the first portion 643a of the third heat dissipation sheet 643 to a third portion 643c of the third heat dissipation sheet 643 and a second portion 643b of the third heat dissipation sheet 643. Since a portion 642a of the second heat dissipation sheet 642 contacts with the second portion 643b of the third heat dissipation sheet 643, the heat conducted along the third heat dissipation sheet 642 may be conducted to the second heat dissipation sheet 642. For example, the heat conducted along the third heat dissipation sheet 643 may be conducted from the second portion 643b of the third heat dissipation sheet 643 to the second heat dissipation sheet 642 through the portion 642a of the second heat dissipation sheet 642. The heat conducted to the portion 642a of the second heat dissipation sheet 642 may be conducted along the second heat dissipation sheet 642.

According to an embodiment, the heat caused from the one or more electronic components 622 may diffuse to an entire area of the first temple 603 through the first heat dissipation sheet 641, the third heat dissipation sheet 643, and the second heat dissipation sheet 642. A conduction path of the heat caused from the one or more electronic components 622 may be referred to as a first conduction path formed along the printed circuit board 621 - the first heat dissipation sheet 641 - the third heat dissipation sheet 643 - and the second heat dissipation sheet 642. As the heat caused from the one or more electronic components 622 may diffuse from the first heat dissipation sheet 641 to the second heat dissipation sheet 642 through the third heat dissipation sheet 643, even when the first heat dissipation sheet 641 and the second heat dissipation sheet 642 are separated, the heat may be effectively dissipated.

According to an embodiment, the third heat dissipation sheet 643 may be configured to conduct heat caused from the first speaker 631 and transferred to the second heat dissipation sheet 642, to the first heat dissipation sheet 641 spaced apart from the second heat dissipation sheet 642.

According to an embodiment, heat may be emitted when the first speaker 631 operates. The heat emitted from the first speaker 631 may be transferred to the second heat dissipation sheet 642 facing the first speaker 631. The heat transferred to the second heat dissipation sheet 642 may be conducted along the second heat dissipation sheet 642. Since the portion 642a of the second heat dissipation sheet 642 contacts with the second portion 643b of the third heat dissipation sheet 643, the heat conducted along the second heat dissipation sheet 642 may be conducted to the third heat dissipation sheet 643. The heat conducted to the third heat dissipation sheet 643 may be conducted along the third heat dissipation sheet 643. For example, the heat conducted from the second heat dissipation sheet 642 to the third heat dissipation sheet 643 may be conducted from the second portion 643b of the third heat dissipation sheet 643 to the third portion 643c of the third heat dissipation sheet 643 and the first portion 643a of the third heat dissipation sheet 643. Since the portion 641a of the first heat dissipation sheet 641 contacts with the first portion 643a of the third heat dissipation sheet 643, the heat conducted along the third heat dissipation sheet 643 may be conducted to the first heat dissipation sheet 641. For example, the heat conducted along the third heat dissipation sheet 643 may be conducted from the first portion 643a of the third heat dissipation sheet 643 to the first heat dissipation sheet 641 through the portion 641a of the first heat dissipation sheet 641. The heat conducted to the portion 641a of the first heat dissipation sheet 641 may be conducted along the first heat dissipation sheet 641.

According to an embodiment, the heat caused from the first speaker 631 may diffuse to the entire area of the first temple 603 through the second heat dissipation sheet 642, the third heat dissipation sheet 643, and the first heat dissipation sheet 641. A conduction path of the heat caused from the first speaker 631 may be referred to as a second conduction path formed along the second heat dissipation sheet 642 - the third heat dissipation sheet 643 - and the first heat dissipation sheet 641. As the heat caused from the first speaker 631 may diffuse from the second heat dissipation sheet 642 to the first heat dissipation sheet 641 through the third heat dissipation sheet 643, even when the first heat dissipation sheet 641 and the second heat dissipation sheet 642 are separated, the heat may be effectively dissipated.

According to an embodiment, since a first adhesive 860 attaching the first speaker 631 to the first sidewall 611 is spaced apart from the second heat dissipation sheet 642, it may firmly attach the first speaker 631 to the first sidewall 611. The first adhesive 860 may include a portion 861 disposed on a third portion 611c of the first sidewall 611 to seal a periphery of the first speaker 631. The periphery of the first speaker 631 may be sealed through the first adhesive 860 including the portion 861.

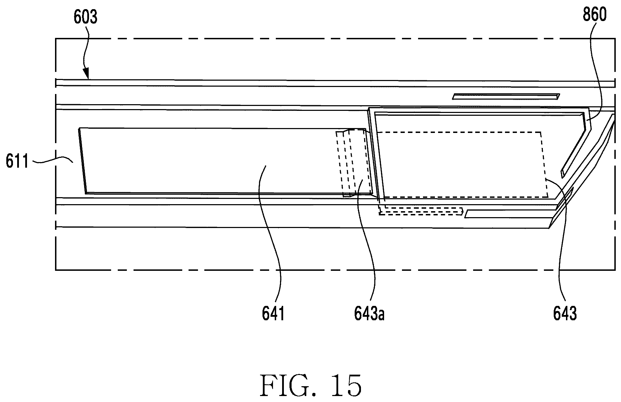

FIG. 15 illustrates the inside of a first temple according to an embodiment in which a printed circuit board and a first speaker are omitted.

Referring to FIG. 15, a second heat dissipation sheet (e.g., the second heat dissipation sheet 642 of FIG. 7) may be omitted, and a third heat dissipation sheet 643 may extend from a first portion 643a contacted with a first heat dissipation sheet 641 toward a direction away from the first heat dissipation sheet 641. For example, the second heat dissipation sheet 642 may not be disposed on a second portion 611b of a first sidewall 611. Instead of the second heat dissipation sheet 642, the third heat dissipation sheet 643 may extend in the direction away from the first heat dissipation sheet 641. Since the second heat dissipation sheet 642 is omitted, the third heat dissipation sheet 643 may extend in the first sidewall 611 without being exposed over the second portion 611b of the first sidewall 611. As a third portion 643c of the third heat dissipation sheet 643 extends in the direction away from the first heat dissipation sheet 641, heat caused from one or more electronic components (e.g., the one or more electronic components 622 of FIG. 7) disposed on the printed circuit board (e.g., the printed circuit board 621 of FIG. 7) may diffuse to an entire area of a first temple 603 along the first heat dissipation sheet 641 and the third heat dissipation sheet 643.

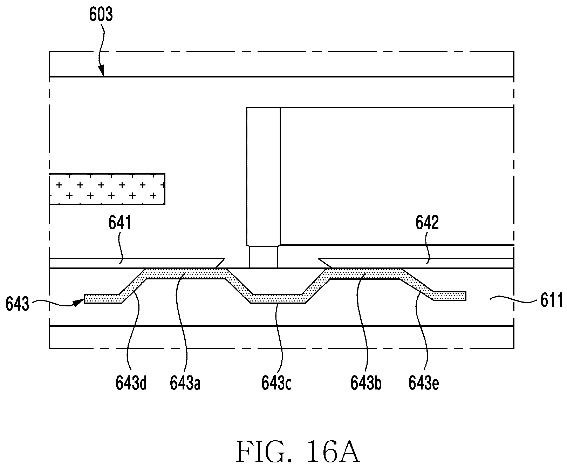

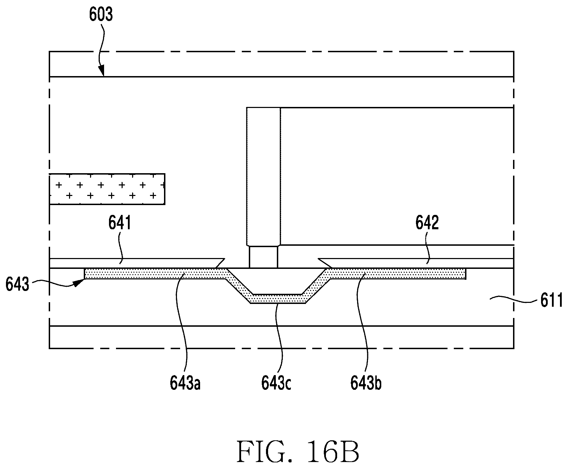

FIGS. 16A and 16B are cross-sectional views of a first temple according to an embodiment.

Referring to FIG. 16A, a first portion 643a and a second portion 643b of a third heat dissipation sheet 643 may be exposed to the outside of a first sidewall 611 by being disposed on substantially the same surface as the first sidewall 611. For example, when manufacturing a first temple 603, the first temple 603 may be manufactured such that the first sidewall 611 is positioned on the same surface as a front surface of the first portion 643a and a front surface of the second portion 643b. When an injection material injected into a mold is cured in a state where the injection material to form the first temple 603 is not positioned over the first portion 643a of the third heat dissipation sheet 643 and the second portion 643b of the third heat dissipation sheet 643, the first temple 603 illustrated in FIG. 16A may be manufactured.

According to an embodiment, as the first portion 643a of the third heat dissipation sheet 643 and the second portion 643b of the third heat dissipation sheet 643 are exposed to the outside of the first sidewall 611, a first heat dissipation sheet 641 and a second heat dissipation sheet 642 may contact the third heat dissipation sheet 643. For example, as the first heat dissipation sheet 641 is disposed on the first portion 643a of the third heat dissipation sheet 643 exposed in a first portion 611a of the first sidewall 611, the first portion 643a of the third heat dissipation sheet 643 may contact the first heat dissipation sheet 641. As the second heat dissipation sheet 642 is disposed on the second portion 643b of the third heat dissipation sheet 643 exposed in a second portion 611b of the first sidewall 611, the second portion 643b of the third heat dissipation sheet 643 may contact the second heat dissipation sheet 642. The third heat dissipation sheet 643 may thermally connect the first heat dissipation sheet 641 and the second heat dissipation sheet 642 by contacting each of the first heat dissipation sheet 641 and the second heat dissipation sheet 642.

In an example of FIG. 16A, the third heat dissipation sheet 643 is illustrated as including a fourth portion 643d and a fifth portion 643e extending from the first portion 643a of the third heat dissipation sheet 643 to be inserted into the inside of the first sidewall 611, but the present disclosure is not limited thereto. Referring to FIG. 16B, the first portion 643a of the third heat dissipation sheet 643 and/or the second portion 643b of the third heat dissipation sheet 643 may extend substantially flat. For example, the first portion 643a of the third heat dissipation sheet 643 may extend substantially flat and may contact the first heat dissipation sheet 641. For example, the second portion 643b of the third heat dissipation sheet 643 may extend substantially flat and may contact the second heat dissipation sheet 642. In a case of a structure illustrated in FIG. 16B, a contact area between the first heat dissipation sheet 641 and the first portion 643a of the third heat dissipation sheet 643 and/or a contact area between the second heat dissipation sheet 642 and the second portion 643b of the third heat dissipation sheet 643 may be relatively increased, and a dissipation effect by the heat dissipation sheets 641, 642, and 643 may be improved.

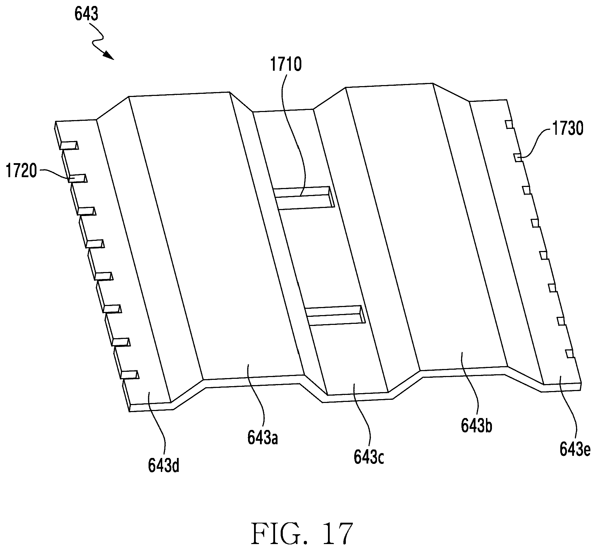

FIG. 17 is a perspective view of a third heat dissipation sheet according to an embodiment.

Referring to FIG. 17, a third heat dissipation sheet 643 may include one or more first through holes 1710 formed in a third portion 643c. For example, the one or more first through holes 1710 may be formed by penetrating a portion of the third portion 643c of the third heat dissipation sheet 643.

According to an embodiment, the one or more first through holes 1710 may increase a contact area between the third portion 643c of the third heat dissipation sheet 643 and a first sidewall (e.g., the first sidewall 611 of FIG. 7). As described above, a first temple (e.g., the first temple 603 of FIG. 7) and the third heat dissipation sheet 643 may be manufactured through an insert molding process. When the third heat dissipation sheet 643 including the one or more first through holes 1710 is placed into a mold for manufacturing the first temple 603, and injection materials forming the first temple 603 are injected, the injection materials may be inserted into the one or more first through holes 1710. When the injection materials are cured in a state where the injection materials are positioned inside the one or more first through holes 1710, a portion of the first sidewall 611 may be formed inside the one or more first through holes 1710. A contact area between the first sidewall 611 and the third portion 643c of the third heat dissipation sheet 643 may be increased by an area of a side surface of the one or more first through holes 1710. As the contact area is increased, the third portion 643c of the third heat dissipation sheet 643 may be stably coupled in the first sidewall 611.

Referring to FIG. 17, the third heat dissipation sheet 643 may include one or more second through holes 1720 formed in a fourth portion 643d and/or one or more third through holes 1730 formed in a fifth portion 643e. For example, the one or more second through holes 1720 may be formed by penetrating a portion of the fourth portion 643d of the third heat dissipation sheet 643. The one or more third through holes 1730 may be formed by penetrating a portion of the fifth portion 643e of the third heat dissipation sheet 643.

According to an embodiment, the one or more second through holes 1720 may increase a contact area between the fourth portion 643d of the third heat dissipation sheet 643 and the first sidewall (e.g., the first sidewall 611 of FIG. 7). The one or more third through holes 1730 may increase a contact area between the fifth portion 643e of the third heat dissipation sheet 643 and the first sidewall 611. Descriptions of the one or more first through holes 1710 may be substantially identically applied to each of the one or more second through holes 1720 and/or the one or more third through holes 1730. As a portion of the first sidewall 611 is formed inside the one or more second through holes 1720 and/or the one or more third through holes 1730, the contact area between the first sidewall 611 and the fourth portion 643d of the third heat dissipation sheet 643 and/or the contact area between the first sidewall 611 and the fifth portion 643e of the third heat dissipation sheet 643 may be increased. The third heat dissipation sheet 643 may be stably coupled to the first sidewall 611 through the one or more second through holes 1720 and/or the one or more third through holes 1730.

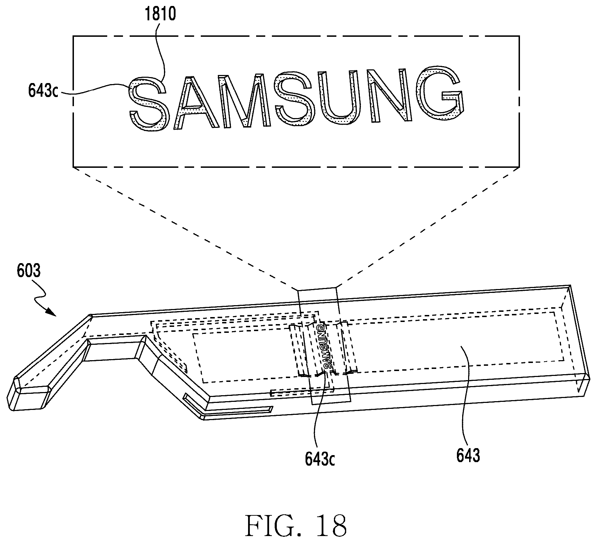

FIG. 18 illustrates a first temple including a recess.

Referring to FIG. 18, a first temple 603 may include a recess 1810 having a defined shape. For example, the recess 1810 may allow a third portion 643c of a third heat dissipation sheet 643 inserted into a first sidewall 611 of the first temple 603 to be visible from the outside of the first temple 603. The recess 1810 may extend from an outer surface of the first temple 603 toward the inside of the first temple 603 such that a portion of the third portion 643c of the third heat dissipation sheet 643 may be visible from the outside of the first temple 603. The recess 1810 of the first temple 603 may be formed by removing a portion of the first temple 603. The recess 1810 may be referred to as an engraved structure in terms of extending from the outer surface of the first temple 603 toward the inside of the first temple 603.

According to an embodiment, a portion of the third portion 643c corresponding to the recess 1810 may be visible from the outside of the first temple 603 through the recess 1810. As the third heat dissipation sheet 643 is disposed in the first temple 603 in which the recess 1810 is formed, the portion of the third portion 643c corresponding to the recess 1810 may be visible from the outside of the first temple 603 through the recess 1810. The portion of the third portion 643c visible through the recess 1810 may be visible from the outside of the first temple 603 according to the defined shape of the recess 1810. The recess 1810 may have the defined shape such as a trademark, a logo, or text. The portion of the third portion 643c visible through the recess 1810 may enhance a design of the first temple 603. For example, in a case that the third heat dissipation sheet 643 is formed from a metal material (e.g., copper), the third heat dissipation sheet 643 may have a unique color of the metal material. As the third portion 643c is visible through the recess 1810 having the defined shape, a pattern having the unique color may be formed.

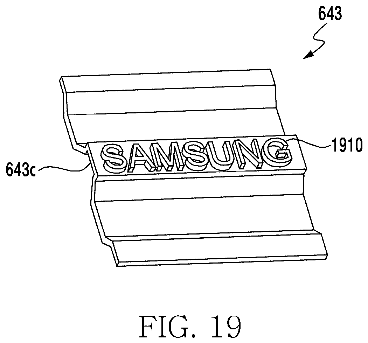

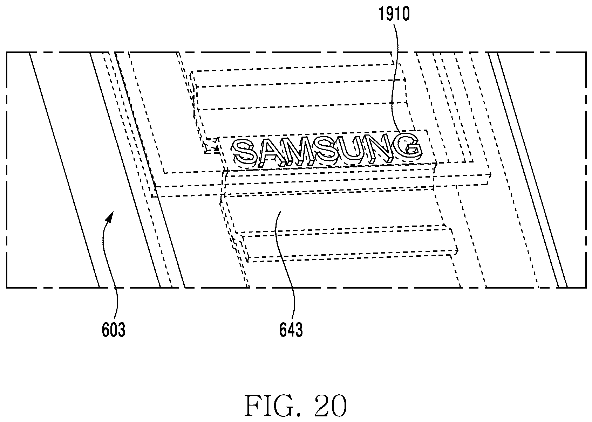

FIG. 19 illustrates a third heat dissipation sheet including a protrusion. FIG. 20 illustrates a first temple in which a third heat dissipation sheet including a protrusion is disposed.

Referring to FIG. 19, a third heat dissipation sheet 643 may include a protrusion 1910. The protrusion 1910 may protrude from a third portion 643c toward a first temple (e.g., the first temple 603 of FIG. 6). The protrusion 1910 may have a defined shape such as a trademark, a logo, or text. The protrusion 1910 may be formed on the third portion 643c of the third heat dissipation sheet 643.

Referring to FIG. 20, when the third heat dissipation sheet 643 including the protrusion 1910 is disposed in the first temple 603, the protrusion 1910 may be exposed to an outer surface of the first temple 603. For example, the protrusion 1910 of the third heat dissipation sheet 643 may form substantially the same plane as the outer surface of the first temple 603 by protruding from the third portion 643c toward the outer surface of the first temple 603. For example, when manufacturing the first temple 603, the third heat dissipation sheet 643 including the protrusion 1910 may be disposed inside a mold having a shape corresponding to a shape of the first temple 603. In a state where the third heat dissipation sheet 643 is positioned in a position where the protrusion 1910 of the third heat dissipation sheet 643 forms substantially the same plane as the outer surface of the first temple 603, injection materials forming the first temple 603 may be injected into the mold. As the injection materials are cured, the protrusion 1910 of the third heat dissipation sheet 643 may form substantially the same plane as the outer surface of the first temple 603.

As described above, the recess 1810 of the first temple 603 illustrated in FIG. 18 may be formed by removing a portion of the first temple 603. In contrast, the first temple 603 illustrated in FIG. 20 may be manufactured such that the protrusion 1910 of the third heat dissipation sheet 643 forms substantially the same plane as the outer surface of the first temple 603 without going through a process of removing a portion of the first temple 603. Since the injection materials forming the first temple 603 are not injected into a portion occupied by the protrusion 1910, the protrusion 1910 may be naturally exposed to the outside of the first temple 603, when the injection materials are cured. The protrusion 1910 of the third heat dissipation sheet 643 visible from the outside of the first temple 603 may enhance a design of the first temple 603.

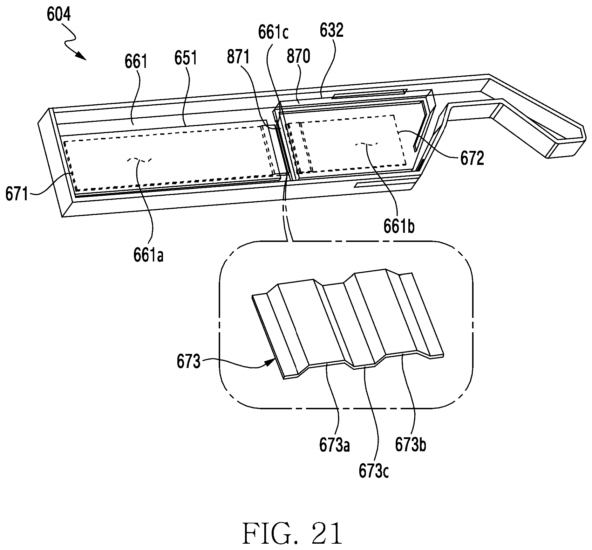

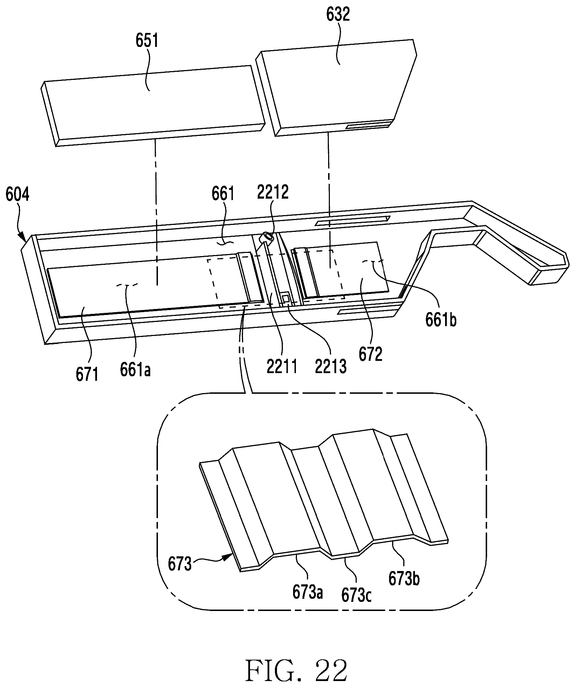

FIG. 21 and FIG. 22 illustrate a second temple.

Referring to FIG. 21, the above descriptions may be substantially identically applied to a fourth heat dissipation sheet 671, a fifth heat dissipation sheet 672, and a sixth heat dissipation sheet 673 included in a second temple 604.

According to an embodiment, the second temple 604 may include a second sidewall 661. For example, a battery 651 and a second speaker 632 may be disposed in the second temple 604. The fourth heat dissipation sheet 671, the fifth heat dissipation sheet 672, and the sixth heat dissipation sheet 673 may be configured to dissipate heat caused from the battery 651 and the second speaker 632.

According to an embodiment, the second speaker 632 may be attached onto the second sidewall 661 through a second adhesive 870. As described above, in a case where the second adhesive 870 overlaps a heat dissipation sheet formed from heat dissipating materials, the second adhesive 870 may be detached.

According to an embodiment, the fourth heat dissipation sheet 671 may be disposed on a first portion 661a of the second sidewall 661. The fifth heat dissipation sheet 672 may be disposed on a second portion 661b of the second sidewall 661. The fifth heat dissipation sheet 672 may not contact with the fourth heat dissipation sheet 671 and may be spaced apart from the fourth heat dissipation sheet 671.

According to an embodiment, the sixth heat dissipation sheet 673 may thermally connect the fourth heat dissipation sheet 671 and the fifth heat dissipation sheet 672. The sixth heat dissipation sheet 673 may include a first portion 673a, a second portion 673b, and a third portion 673c. The first portion 673a of the sixth heat dissipation sheet 673 may contact the fourth heat dissipation sheet 671. The second portion 673b of the sixth heat dissipation sheet 673 may contact the fifth heat dissipation sheet 672. The third portion 673c of the sixth heat dissipation sheet 673 may extend from the first portion 673a to the second portion 673b.

According to an embodiment, the third portion 673c of the sixth heat dissipation sheet 673 may be inserted into the second sidewall 661. As the third portion 673c of the sixth heat dissipation sheet 673 is inserted into the second sidewall 661, a portion 871 of the second adhesive 870 may cross a third portion 661c between the first portion 661a of the second sidewall 661 and the second portion 661b of the second sidewall 661. According to an embodiment, the second adhesive 870 may seal a periphery of the second speaker 632.

Referring to FIG. 22, a disposition structure of the heat dissipation sheets (e.g., the first heat dissipation sheet 641, the second heat dissipation sheet 642, and the third heat dissipation sheet 643 of FIG. 11) described above may correspond to the heat dissipation sheets (e.g., the fourth heat dissipation sheet 671, the fifth heat dissipation sheet 672, and the sixth heat dissipation sheet 673) disposed in the second temple 604. For example, the first heat dissipation sheet 641 may correspond to the fourth heat dissipation sheet 671, the second heat dissipation sheet 642 may correspond to the fifth heat dissipation sheet 672, and the third heat dissipation sheet 643 may correspond to the sixth heat dissipation sheet 673.

According to an embodiment, the battery 651 and the second speaker 632 may be disposed in the second temple 604. The second temple 604 may include a structure such as a guide wall 2211 for supporting the battery 651, a hole structure 2212 into which a screw is inserted, or a seating portion 2213 in which a microphone is seated. The guide wall 2211, the hole structure 2212, and the seating portion 2213 may be disposed on a second sidewall 661. By the guide wall 2211, the hole structure 2212, and the seating portion 2213, an integrated heat dissipation sheet may be difficult to be disposed on the second sidewall 661 of the second temple 604.

As described with reference to FIG. 21, the fourth heat dissipation sheet 671 may be disposed on the first portion 661a of the second sidewall 661. The fifth heat dissipation sheet 672 may be disposed on the second portion 661b of the second sidewall 661. The fifth heat dissipation sheet 672 may not contact with the fourth heat dissipation sheet 671 and may be spaced apart from the fourth heat dissipation sheet 671. The guide wall 2211, the hole structure 2212, and the seating portion 2213 may be positioned between the fourth heat dissipation sheet 671 and the fifth heat dissipation sheet 672.

According to an embodiment, the sixth heat dissipation sheet 673 may thermally connect the fourth heat dissipation sheet 671 to the fifth heat dissipation sheet 672. The sixth heat dissipation sheet 673 may include the first portion 673a, the second portion 673b, and the third portion 673c. The first portion 673a of the sixth heat dissipation sheet 673 may contact the fourth heat dissipation sheet 671. The second portion 673b of the sixth heat dissipation sheet 673 may contact the fifth heat dissipation sheet 672. The third portion 673c of the sixth heat dissipation sheet 673 may be inserted into the second sidewall 661 and extend from the first portion 673a to the second portion 673b. In portions in which the heat dissipation sheet is difficult to dispose, such as the guide wall 2211, the hole structure 2212, or the seating portion 2213, the fourth heat dissipation sheet 671 and the fifth heat dissipation sheet 672 spaced apart from each other may be thermally connected by the third portion 673c of the sixth heat dissipation sheet 673 being inserted into the second sidewall 661. In addition, in a portion in which the heat dissipation sheet is difficult to dispose, a heat dissipation sheet having a structure identical or similar as the third heat dissipation sheet 643 or the sixth heat dissipation sheet 673 may be disposed.

The effects that may be obtained from the present disclosure are not limited to those described above, and any other effects not mentioned herein will be clearly understood by those skilled in the art to which the present disclosure belongs.

A head-wearable device 101, 200, 400, or 600 is provided. The head-wearable device 101, 200, 400, or 600 may comprise a housing part 603, including a sidewall 611, contacted with a portion of a user's body when the head-wearable device 101, 200, 400, or 600 is worn by the user, and supporting the head-wearable device 101, 200, 400, or 600. The head-wearable device 101, 200, 400, or 600 may comprise one or more electronic components 622 disposed on the housing part 603. For example, the one or more electronic components 622 may be disposed on a printed circuit board 621 disposed in the housing part 603. The head-wearable device 101, 200, 400, or 600 may comprise a first heat dissipation sheet 641, disposed on a first portion 611a of the sidewall 611 of the housing part, configured to dissipate heat caused from the one or more electronic components 622. The head-wearable device 101, 200, 400, or 600 may comprise a second heat dissipation sheet 642, spaced apart from the first heat dissipation sheet 641, disposed on a second portion 611b of the sidewall 611 of the housing part. The head-wearable device 101, 200, 400, or 600 may comprise a speaker 631, attached to the sidewall 611, disposed over the second portion 611b and a third portion 611c of the sidewall 611 through an adhesive 860 on the sidewall 611. The speaker 631 may be spaced apart from the printed circuit board 621. A portion 861 of the adhesive 860 may be disposed on the third portion 611c of the sidewall 611 to seal a periphery of the speaker 631, and the third portion 611c of the sidewall 611 may be positioned between the first portion 611a of the sidewall 611 and the second portion 611b of the sidewall 611. The head-wearable device 101, 200, 400, or 600 may comprise a third heat dissipation sheet 643, thermally connecting the first heat dissipation sheet 641 and the second heat dissipation sheet 642. The third heat dissipation sheet 643 may include a first portion 643a, disposed on the sidewall 611 of the housing part 603, contacted with the first heat dissipation sheet 641, a second portion 643b, disposed on the sidewall 611 of the housing part 603, contacted with the second heat dissipation sheet 642, and a third portion 643c, extending from the first portion 643a of the third heat dissipation sheet 643 to the second portion 643b of the third heat dissipation sheet 641, disposed in the third portion 611c of the sidewall 611 of the housing part. A material forming the third heat dissipation sheet 643 may be different from a material forming the first heat dissipation sheet 641 or the second heat dissipation sheet 642.

According to an embodiment, the adhesive 860 may be attached to the sidewall 611, by being spaced apart from the second heat dissipation sheet 642 disposed on the second portion 611b of the sidewall 611.

According to an embodiment, the head-wearable device 101, 200, 400, or 600 may further comprise a printed circuit board (PCB) 621, spaced apart from the speaker 631, on which the one or more electronic components 622 is disposed, and disposed in the housing part 603. The third heat dissipation sheet 643 may be configured to conduct heat, caused from the one or more electronic components 622 disposed on the PCB 621 and transferred to the first heat dissipation sheet 641 facing the PCB 621, to the second heat dissipation sheet 642 spaced apart from the first heat dissipation sheet 641.

According to an embodiment, the third heat dissipation sheet 643 may be configured to conduct heat, caused from the speaker 631 and transferred to the second heat dissipation sheet 642 disposed below the speaker 631, to the first heat dissipation sheet 641 spaced apart from the second heat dissipation sheet 642.

According to an embodiment, the speaker 631 may include a diaphragm 810 and an enclosure 820, enclosing the diaphragm 810, comprising a first speaker hole 821 to provide a path through which audio signals generated from the diaphragm 810 are transmitted to an outside of the speaker 631. The housing part 603 may include a second speaker hole 851, aligned with the first speaker hole 821 to provide a path through which the audio signals are provided to an outside of the housing part 603.

According to an embodiment, the adhesive 860 may be connected to the second speaker hole 851 through the first speaker hole 821, and may be interposed between a periphery of the enclosure 820 and the sidewall 611 to seal a front chamber 920 formed on a front side of the diaphragm 810.

According to an embodiment, at least one of a front surface of the first portion 643a of the third heat dissipation sheet 643 or a front surface of the second portion 643b of the third heat dissipation sheet 643 may be positioned on substantially a same plane as the sidewall 611.

According to an embodiment, the first heat dissipation sheet 641 or the second heat dissipation sheet 642 may be formed from a graphite, and the third heat dissipation sheet 643 may be formed from a metal material.

According to an embodiment, the third heat dissipation sheet 643 may include one or more through holes 1710, 1720, and 1730 to increase a contact area between the sidewall 611 of the housing part 603 and the third heat dissipation sheet 643.

According to an embodiment, the third heat dissipation sheet 643 may further include a fourth portion 643d extending from the first portion 643a of the third heat dissipation sheet 643 to be inserted into the sidewall 611 of the housing part 603, and a fifth portion 643e extending from the second portion 643b of the third heat dissipation sheet 643 to be inserted into the sidewall 611 of the housing part 603. The first portion 643a of the third heat dissipation sheet 643 may be positioned between the third portion 643c of the third heat dissipation sheet 643 and the fourth portion 643d of the third heat dissipation sheet 643. The second portion 643b of the third heat dissipation sheet 643 may be positioned between the third portion 643c of the third heat dissipation sheet 643 and the fifth portion 643e of the third heat dissipation sheet 643.

According to an embodiment, the housing part 603 may include a recess 1810, having a defined shape, extending from an outer surface of the housing part 603 toward an inside of the housing part 603 such that the third portion 611c of the third heat dissipation sheet 643 is visible from an outside of the housing part 603. A portion of the third portion 611c corresponding to the recess 1810 may be visible from the outside of the housing part 603 through the recess 1810.

According to an embodiment, the third heat dissipation sheet 643 may include a protrusion 1910, having a defined shape, protruding from the third portion 611c of the third heat dissipation sheet 643 toward an outer surface of the housing part 603, and exposed to the outer surface of the housing part 603. The protrusion 1910 may be visible from an outside of the housing part 603.

According to an embodiment, the head-wearable device 101, 200, 400, or 600 may further comprise a display 608 that displays visual information to the user wearing the head-wearable device 101, 200, 400, or 600. The head-wearable device 101, 200, 400, or 600 may further comprise a rim 605 surrounding the display 608. The housing part 603 may include a temple 603, rotatably coupled to the rim 605, contacted with an ear of the user.

According to an embodiment, the head-wearable device 101, 200, 400, or 600 may further include another temple 604, accommodating a battery 651, contacted with another ear of the user, and rotatably coupled to the rim 605.

According to an embodiment, a portion 641a of the first heat dissipation sheet 641 contacted with the first portion 643a of the third heat dissipation sheet 643 may be disposed on the first portion 643a of the third heat dissipation sheet 643. A portion 642a of the second heat dissipation sheet 642 contacted with the second portion 643b of the third heat dissipation sheet 643 may be disposed on the second portion 643b of the third heat dissipation sheet 643.

A head-wearable device 101, 200, 400, and 600 is provided. The head-wearable device 101, 200, 400, or 600 may comprise a display 608. The head-wearable device 101, 200, 400, or 600 may comprise a housing assembly 601. The housing assembly 601 may include a rim 605 surrounding the display 608, and a temple 603, rotatably coupled to the rim 605, comprising a sidewall 611, and supported by an ear of a user when the head-wearable device 101, 200, 400, or 600 is worn by the user. The head-wearable device 101, 200, 400, or 600 may comprise a printed circuit board (PCB) 621 disposed in the temple 603. The head-wearable device 101, 200, 400, or 600 may comprise one or more electronic components 622 disposed on the PCB 621. The head-wearable device 101, 200, 400, or 600 may comprise a first heat dissipation sheet 641, facing the PCB 621, disposed on a first portion 611a of the sidewall 611, and configured to dissipate heat caused from the one or more electronic components 622. The head-wearable device 101, 200, 400, or 600 may comprise a second heat dissipation sheet 642, spaced apart from the first heat dissipation sheet 641, disposed on a second portion 611b of the sidewall 611. The head-wearable device 101, 200, 400, or 600 may comprise a speaker 631, spaced apart from the PCB 621, attached to the sidewall 611 through an adhesive 860 on the sidewall 611, and disposed over the second portion 611b of the sidewall and a third portion 611c of the sidewall 611. A portion 861 of the adhesive 860 may be disposed on the third portion 611c of the sidewall 611 to seal a periphery of the speaker 631. The third portion 611c of the sidewall 611 may be positioned between the first portion 611a of the sidewall 611 and the second portion 611b of the sidewall 611. The head-wearable device 101, 200, 400, or 600 may comprise a third heat dissipation sheet 643, thermally connecting the first heat dissipation sheet 641 and the second heat dissipation sheet 642. The third heat dissipation sheet 643 may include a first portion 643a, disposed on the sidewall 611 of the temple 603, contacted with the first heat dissipation sheet 641, a second portion 643b, disposed on the sidewall 611 of the temple 603, contacted with the second heat dissipation sheet 642, and a third portion 643c, extending from the first portion 643a of the third heat dissipation sheet 643 to the second portion 643b of the third heat dissipation sheet 643, disposed in the third portion 611c of the sidewall 611.

According to an embodiment, the adhesive 860 may be attached to the sidewall 611, by being spaced apart from the second heat dissipation sheet 642 disposed on the first portion 611a of the sidewall 611.

According to an embodiment, the third heat dissipation sheet 643 may be configured to conduct heat, caused from the one or more electronic components 622 disposed on the PCB 621 and transferred to the first heat dissipation sheet 641 facing the PCB 621, to the second heat dissipation sheet 642 spaced apart from the first heat dissipation sheet 641. The third heat dissipation sheet 643 may be configured to conduct heat, caused from the speaker 631 and transferred to the second heat dissipation sheet 642 disposed below the speaker 631, to the first heat dissipation sheet 641 spaced apart from the second heat dissipation sheet 642.

According to an embodiment, the speaker 631 may include a diaphragm 810, and an enclosure 820, enclosing the diaphragm 810, comprising a first speaker hole 821 providing a path through which audio signals generated from the diaphragm 810 are transmitted to an outside of the speaker 631. The temple 603 may include a second speaker hole 851, aligned with the first speaker hole 821, providing a path through which the audio signals are transmitted to an outside of the temple 603. The adhesive 860 may be connected to the second speaker hole 851 through the first speaker hole 821, and may be interposed between a periphery of the enclosure 820 and the sidewall 611 to seal a front chamber 920 formed on a front side of the diaphragm 810.

According to an embodiment, the housing assembly 601 may further include another temple 604, rotatably coupled to the rim, including another sidewall 661, and supported by another ear of the user when the head-wearable device 101, 200, 400, or 600 is worn by the user. The wearable device 101, 200, 400, or 600 may comprise a battery 651 disposed in the other temple 604. The wearable device 101, 200, 400, or 600 may comprise a fourth heat dissipation sheet 671, facing the battery 651, disposed on a first portion 661a of the other sidewall 661, and may be configured to dissipate heat caused from the battery 651. The wearable device 101, 200, 400, or 600 may comprise a fifth heat dissipation sheet 672, spaced apart from the fourth heat dissipation sheet 671, disposed on a second portion 661b of the other sidewall 661. The wearable device 101, 200, 400, or 600 may comprise another speaker 632, spaced apart from the battery 651, attached to the other sidewall 661 through another adhesive 870 on the other sidewall 661, and disposed over the second portion 661b and a third portion 661c of the other sidewall 661. A portion 871 of the other adhesive 870 may be disposed on the third portion 661c of the other sidewall 661 to seal a periphery of the other speaker 632. The third portion 661c of the other sidewall 661 may be positioned between the first portion 661a of the other sidewall 661 and the second portion 661b of the other sidewall 661. The wearable device 101, 200, 400, or 600 may comprise a sixth heat dissipation sheet 673, thermally connecting the fourth heat dissipation sheet 671 and the fifth heat dissipation sheet 672. The sixth heat dissipation sheet 673 may include a first portion 673a, disposed on the other sidewall 661 of the other temple 604, contacted with the fourth heat dissipation sheet 671, a second portion 673b disposed on the other sidewall 661 of the other temple 604, contacted with the fifth heat dissipation sheet 672, and a third portion 673c, extending from the first portion 673a of the sixth heat dissipation sheet 673 to the second portion 673b of the sixth heat dissipation sheet 673, disposed in the third portion 661c of the other sidewall 661.

A wearable device is provided. The wearable device comprises a housing, the housing comprising at least one surface on an interior of the housing. The wearable device further comprises a first heat dissipation sheet, which is disposed on a first portion of the at least one surface and configured to dissipate heat generated by the one or more electronic components. The wearable device further comprises a second heat dissipation sheet, which is disposed on a second portion of the at least one surface and configured to dissipate heat generated by the one or more electronic components, the second heat dissipation sheet being spaced apart from the first heat dissipation sheet. The wearable device further comprises a speaker, which is disposed over the second potion of the at least one surface and a third portion of the at least one surface through an adhesive, the third portion of the at least one surface being positioned between the first portion of the at least one surface and the second portion of the at least one surface. The wearable device further comprises a heat dissipation member, thermally connecting the first heat dissipation sheet and the second heat dissipation sheet. The heat dissipation member comprises a first portion, disposed on the at least one surface, contacted with the first heat dissipation sheet. The heat dissipation member further comprises a second portion, disposed on the at least one surface, contacted with the first heat dissipation sheet. The heat dissipation member further comprises a third portion, extending from the first portion of the third heat dissipation sheet to the second portion of the third dissipation sheet, the third portion of the heat dissipation member being disposed away from the third portion of the at least one surface.

The wearable device may be a device which is suitable for being worn by a user. The wearable device may be a device which is worn on the head. The wearable device may be a head wearable device. Alternatively or in addition, the wearable device may be a device which is worn on a part of the user other than the head, such as the wrist.

The housing may contact a portion of a user's body when worn by the user. The at least one surface on the interior of the housing may be a surface of a sidewall of the housing. Where the at least one surface on the interior of the housing is a surface of a sidewall of the housing, the sidewall may contact a portion of a user's body when worn by the user.

The first heat dissipation sheet may be arranged to dissipate heat generated by the speaker. The second heat dissipation sheet may be arranged to dissipate heat generated by the speaker. The heat dissipation member may be arranged to dissipate heat generated by the speaker.

The wearable device may further comprise one or more electronic components disposed in an interior of the housing. The first heat dissipation sheet may be arranged to dissipate heat generated by the one or more electronic components. The second heat dissipation sheet may be arranged to dissipate heat generated by the one or more electronic components. The first heat dissipation sheet may be arranged to dissipate heat generated by the speaker. The heat dissipation member may be arranged to dissipate heat generated by the one or more electronic components.

The heat dissipation member may be a third heat dissipation sheet.

The third portion of the heat dissipation member may be contained within a sidewall of the housing.

A material forming the heat dissipation member may be different from a material forming the first heat dissipation sheet. A material forming the heat dissipation member may be different from a material forming the second heat dissipation sheet.

The effects that may be obtained from the present disclosure are not limited to those described above, and any other effects not mentioned herein will be clearly understood by those having ordinary knowledge in the art to which the present disclosure belongs.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

It will be appreciated that all of the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.

## Claims

1. A head-wearable device comprising:
a housing part, including a sidewall, contacted with a portion of a user's body when the head-wearable device is worn by the user, and supporting the head-wearable device;
one or more electronic components disposed on the housing part;
a first heat dissipation sheet, disposed on a first portion of the sidewall of the housing part, configured to dissipate heat caused from the one or more electronic components;
a second heat dissipation sheet, spaced apart from the first heat dissipation sheet, disposed on a second portion of the sidewall;
a speaker, disposed over the second portion of the sidewall and a third portion of the sidewall through an adhesive, the third portion of the sidewall positioned between the first portion of the sidewall and the second portion of the sidewall; and
a third heat dissipation sheet, thermally connecting the first heat dissipation sheet and the second heat dissipation sheet, the third heat dissipation sheet including:
a first portion, disposed on the sidewall of the housing part, contacted with the first heat dissipation sheet,
a second portion, disposed on the sidewall of the housing part, contacted with the second heat dissipation sheet, and
a third portion, extending from the first portion of the third heat dissipation sheet to the second portion of the third heat dissipation sheet, disposed in the third portion of the sidewall, and
wherein a material forming the third heat dissipation sheet is different from a material forming the first heat dissipation sheet or the second heat dissipation sheet.

2. The head-wearable device of claim 1,
wherein the adhesive is attached to the sidewall, by being spaced apart from the second heat dissipation sheet disposed on the second portion of the sidewall.

3. The head-wearable device of claim 1 or 2, further comprising a printed circuit board (PCB), spaced apart from the speaker, on which the one or more electronic components is disposed, and disposed in the housing part, and
wherein the third heat dissipation sheet is configured to conduct heat, caused from the one or more electronic components disposed on the PCB and transferred to the first heat dissipation sheet facing the PCB, to the second heat dissipation sheet spaced apart from the first heat dissipation sheet.

4. The head-wearable device of any one of claims 1 to 3,
wherein the third heat dissipation sheet is configured to conduct heat, caused from the speaker and transferred to the second heat dissipation sheet disposed below the speaker, to the first heat dissipation sheet spaced apart from the second heat dissipation sheet.

5. The head-wearable device of any one of claims 1 to 4,
wherein the speaker includes:
a diaphragm, and
an enclosure, enclosing the diaphragm, comprising a first speaker hole configured to provide a path through which audio signals generated from the diaphragm are transmitted to an outside of the speaker, and
wherein the housing part includes a second speaker hole, aligned with the first speaker hole of the enclosure, configured to provide a path through which the audio signals are transmitted to an outside of the housing part.

6. The head-wearable device of claim 5,
wherein the adhesive is connected to the second speaker hole through the first speaker hole of the enclosure, and is interposed between a periphery of the enclosure and the sidewall to seal a front chamber formed on a front side of the diaphragm.

7. The head-wearable device of any one of claims 1 to 6,
wherein at least one of a front surface of the first portion of the third heat dissipation sheet or a front surface of the second portion of the third heat dissipation sheet and the sidewall are positioned substantially on a same plane.

8. The head-wearable device of any one of claims 1 to 7,
wherein the first heat dissipation sheet or the second heat dissipation sheet is formed from a graphite, and
wherein the third heat dissipation sheet is formed from a metal material.

9. The head-wearable device of any one of claims 1 to 8,
wherein the third heat dissipation sheet includes one or more through holes to increase a contact area between the sidewall of the housing part and the third heat dissipation sheet.

10. The head-wearable device of any one of claims 1 to 9,
wherein the third heat dissipation sheet includes:
a fourth portion extending from the first portion of the third heat dissipation sheet to be inserted into the sidewall of the housing part, and
a fifth portion extending from the second portion of the third heat dissipation sheet to be inserted into the sidewall of the housing part,
wherein the first portion of the third heat dissipation sheet is positioned between the third portion of the third heat dissipation sheet and the fourth portion of the third heat dissipation sheet, and
wherein the second portion of the third heat dissipation sheet is positioned between the third portion of the third heat dissipation sheet and the fifth portion of the third heat dissipation sheet.

11. The head-wearable device of any one of claims 1 to 10,
wherein the housing part includes a recess, having a defined shape, extending from an outer surface of the housing part toward an inside of the housing part such that the third portion of the third heat dissipation sheet is visible from an outside of the housing part, and
wherein a portion of the third portion corresponding to the recess is visible from the outside of the housing part through the recess.

12. The head-wearable device of any one of claims 1 to 11,
wherein the third heat dissipation sheet includes a protrusion, having a defined shape, protruding from the third portion of the third heat dissipation sheet toward an outer surface of the housing part, and exposed to the outer surface of the housing part, and
wherein the protrusion of the third heat dissipation sheet is visible from an outside of the housing part.

13. The head-wearable device of any one of claims 1 to 12, further comprising:
a display that displays visual information to the user wearing the head-wearable device; and
a rim surrounding the display, and
wherein the housing part includes a temple, rotatably coupled to the rim, contacted with an ear of the user.

14. The head-wearable device of claim 13,
wherein the housing part further includes another temple, accommodating a battery, contacted with another ear of the user, and rotatably coupled to the rim.

15. The head-wearable device of any one of claims 1 to 14,
wherein a portion of the first heat dissipation sheet contacted with the first portion of the third heat dissipation sheet is disposed on the first portion of the third heat dissipation sheet, and
wherein a portion of the second heat dissipation sheet contacted with the second portion of the third heat dissipation sheet is disposed on the second portion of the third heat dissipation sheet.
